(19) Europäisches Patentamt
European Patent Office
Office européen des brevets

(11) EP 4 396 302 B1

(12) EUROPEAN PATENT SPECIFICATION

(45) Date of publication and mention of the grant of the patent:
**24.12.2025 Bulletin 2025/52**

(21) Application number: **22769726.5**

(22) Date of filing: **31.08.2022**

(51) International Patent Classification (IPC):
***C09K 11/02*** (2006.01) ***C09K 11/56*** (2006.01)
***C09K 11/70*** (2006.01) ***C09K 11/88*** (2006.01)
***H10K 59/00*** (2023.01) ***C09D 11/101*** (2014.01)
***G02F 1/13357*** (2006.01) ***H10K 59/38*** (2023.01)
***H10H 20/851*** (2025.01) ***C09D 11/50*** (2014.01)
*H10K 101/00* (2023.01) *H10H 20/80* (2025.01)
*H10K 102/00* (2023.01)

(52) Cooperative Patent Classification (CPC):
**C09K 11/02; C09D 11/101; C09D 11/50; C09K 11/565; C09K 11/70; C09K 11/883; G02F 1/133617; H10H 20/8516; H10K 59/38;**
H10H 20/882; H10K 2101/80; H10K 2102/331

(86) International application number:
**PCT/EP2022/074141**

(87) International publication number:
**WO 2023/031238 (09.03.2023 Gazette 2023/10)**

(54) **COMPOSITION**

ZUSAMMENSETZUNG

COMPOSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.09.2021 EP 21194783**

(43) Date of publication of application:
**10.07.2024 Bulletin 2024/28**

(73) Proprietor: **Samsung Electronics Co., Ltd**
**Suwon-si, Gyeonggi-do 16677 (KR)**

(72) Inventors:
- **KOSSOY, Elizaveta**
**91390 JERUSALEM (IL)**
- **YAKOBI, Ravit**
**91390 JERUSALEM (IL)**
- **AVIV, Yaron**
**91390 JERUSALEM (IL)**
- **AZOUBEL, Suzanna**
**91390 JERUSALEM (IL)**
- **DAVIDI, Inbal**
**91390 JERUSALEM (IL)**
- **KOEHLER, Ingo**
**64293 DARMSTADT (DE)**
- **BURSCHKA, Julian**
**64293 DARMSTADT (DE)**

(74) Representative: **Appleyard Lees IP LLP**
**15 Clare Road**
**Halifax HX1 2HY (GB)**

(56) References cited:
**US-A- 4 891 527** **US-A1- 2007 228 932**
**US-A1- 2016 027 971** **US-A1- 2016 322 542**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 396 302 B1

## Description

### Field of the invention

The present invention relates to a layer, a multiple layer, a color conversion device and an optical device containing at least one color conversion device.

### Background Art

WO 2017/054898 A1 describes a composition comprising red emission type nanocrystals, wetting and dispersing agent, propylene glycol monomethyl ether acetate as a solvent, an acryl polymer mixture including an acrylic unit including an acid group and a silane modified acrylic unit.

WO 2019/002239 A1 discloses a composition comprising a semiconducting light emitting nanoparticles, a polymer and a (meth)acrylate such as 1.4. cyclohexanedimethanol-monoacrylate having high viscosity around 90 cp.

US2007/0228932 discloses a light-emitting device, method for producing the same and fluorescent device. US2016/0322542 discloses a method of manufacturing a light-emitting device. US2016/0027971 discloses wavelength converters and methods for making the same.

### Patent Literature

1. WO 2017/054898 A1
2. WO 2019/002239 A1

### Summary of the invention

However, the inventors newly have found that there are still one or more of considerable problems for which improvement is desired, as listed below:
realizing improved layer brightness of a cured composition film, realizing improved optical performance (e.g. higher EQE value of the cured composition film) after curing the composition either at low UV intensity (e.g. UV curing at 2.3mW/$cm^2$) or at high UV light intensity (e.g. UV curing 10 sec at 300 mW/$cm^2$), preferably realizing improved optical performance (e.g. higher EQE of the cured composition film) after curing the composition at high UV light intensity (e.g. UV curing 10 sec at 300 mW/$cm^2$) and/or improved film layer condition such as improved thermal stability of the layer, mitigation/prevention of EQE drop following thermal treatment of the layer, preferably realizing these at the same time; realizing improved film brightness after polymerization of the composition at high UV light intensity and long term durability of the cured film; realizing blue shift of the peak maximum wavelength (PWL) of light from a cured composition film layer, improved PWL value of the film layer, reducing/preventing red shift of the peak maximum wavelength of light emitted from a cured composition film layer.

The inventors aimed to solve one or more of the above-mentioned problems.

The present inventors have surprisingly found that one or more of the above described technical problems can be solved by the features as defined in the claims.

According to the present invention, there is provided a layer according to claim 1, 2, 3 or 4, a multiple layer according to claim 11, a color conversion device according to claim 12 and an optical device according to claim 13.

Namely, it was found a novel layer (100) comprising at least a matrix material (110) and one or more light emitting moieties (120), wherein the distribution of the light emitting moiety (120) in the layer is not identical in the direction of layer thickness, preferably the concentration of the light emitting moiety (120) in the layer varies in the direction of the layer thickness, more preferably the concentration of the light emitting moiety (120) in the layer varies from a low concentration on one side of the layer to an high concentration on the opposite side of the layer, preferably said one side is the upper side (140) of the layer or the lower side (150) of the layer.

In another aspect, the present invention relates to a layer (100) containing at least a matrix material (110) and one or more light emitting moieties (120), contains a 1$^{st}$ phase (210) and a 2$^{nd}$ phase (220), wherein said 1$^{st}$ phase (210) and said 2$^{nd}$ phase (220) are different of each other and said 1$^{st}$ phase (210) has a plurality of aggregates (211) of said light emitting moieties (120) and higher concentration of the light emitting moieties per unit volume in the 1$^{st}$ phase (210) than in the 2$^{nd}$ phase (220), preferably said unit volume is 1$cm^3$, wherein the concentration of the 1$^{st}$ phase (210) in the layer varies from a low concentration on one side of the layer to an high concentration on the opposite side of the layer, whereas the concentration of the 2$^{nd}$ phase (220) in the layer varies in contrary from a high concentration on the one side of the layer to a low concentration on the opposite side of the layer, preferably said one side is the upper side (140) of the layer or the lower

side (150) of the layer.

In another aspect, the present invention relates to a layer (100) containing at least a matrix material (110) and one or more light emitting moieties (120), wherein 30 wt% or more of the light emitting moieties (120) based on the total amount of the light emitting moieties in the layer are concentrated in an area (160) of the layer, wherein said area (160) has the thickness within 25% of the thickness of the layer; preferably the area (160) is placed at any point in the layer, more preferably said area (160) is placed in the bottom side (170) of the layer that is within 25% of the layer thickness from the bottom surface (240) of the layer to the top surface (230) of the layer, or middle part (180) of the layer that has the thickness within 25% of the layer thickness, or the top side (190) of the layer that is within 25% of the layer thickness from the top surface (230) of the layer to the bottom surface (240) of the layer, preferably the area (160) is placed in the bottom side (170) of the layer or in the top side (190) of the layer, preferably from 30wt% to 70wt% of the light emitting moieties based on the total amount of the light emitting moieties in the layer are concentrated in the area (160), more preferably 40 to 60wt%.

In another aspect, the present invention relates to a layer (100) containing at least a matrix material (110) and one or more light emitting moieties (120), wherein 41 wt.% or more of the light emitting moieties (120) based on the total amount of the light emitting moieties **in** the layer are concentrated in the area (160) of the layer, wherein said area (160) has the thickness within 40% of the thickness of the layer; preferably the area (160) is placed at any point in the layer, more preferably said area (160) is placed in the bottom side (170) of the layer that is within 40% of the layer thickness from the bottom surface (240) of the layer to the top surface (230) of the layer, the top side (190) of the layer that is within 40% of the layer thickness from the top surface (230) of the layer to the bottom surface (240) of the layer or the middle part (180) of the layer that has the thickness within 40% of the layer thickness, preferably the area (160) is placed in the bottom side (170) of the layer or in the top side (190) of the layer, preferably from 45wt% to 90wt% of the light emitting moieties based on the total amount of the light emitting moieties in the layer are concentrated in the area (160), more preferably 50wt% to 85wt% even more preferably from 65wt% to 80wt%.

A process of fabricating the layer (100) may be provided, wherein the process comprises at least the following steps;

I) providing a composition preferably from a photocurable composition, comprising at least;

i) a reactive monomer, preferably said monomer contains one or more of functional groups, more preferably said monomer is a (meth)acrylate monomer;
ii) a light emitting moiety; and optionally
iii) a chemical compound comprising at least one end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid group, preferably said group is a phosphate group, a phosphonate group, thiol group, primary amine group and a carboxyl group, more preferably it is a carboxyl group as defined in the present invention onto a substrate,

II) curing the composition, preferably said curing is performed by photo irradiation and/or thermal treatment, more preferably said curing is performed by photo irradiation.

A layer (100) obtained or obtainable from the process may be provided.

In another aspect, the present invention relates to a multiple layer (300) containing at least the layer of the present invention and one another layer (310) directly attached onto the layer of the present invention.

In another aspect, the present invention further relates to a color conversion device (400) comprising at least xi) a pixel partly or fully filled with the layer (100) of the present invention or the multiple layer (300) of the present invention, preferably said pixel is a 1$^{st}$ pixel (411) and/or a 2$^{nd}$ pixel (412),

optionally one or more of another layers (420) placed under and/or above the layer (100) in the pixel, preferably said another layer (420) contains a matrix material (110) and it does not contain the light emitting moiety (120); and
xii) a bank (430) comprising at least a polymer material, preferably the color conversion device (400) further contains a supporting medium (440).

A use of the disclosed composition for fabricating the layer of the present invention or the device (100) of the present invention may be provided.

In another aspect, the present invention furthermore relates to an optical device (500) containing at least one functional medium (510) configured to modulate a light or configured to emit light, and the color conversion device (400) of the present invention.

Further advantages of the present invention will become evident from the following detailed description.

**Description of drawings**

Fig. 1A: shows a cross sectional view of a schematic of one embodiment of the layer (100) of the present invention.

Fig. 1B: shows a cross sectional view of a schematic of another embodiment of the layer (100) of the present invention.

Fig. 1C: shows a cross sectional view of a schematic of another embodiment of the layer (100) of the present invention.

Fig. 1D: shows a cross sectional view of a schematic of another embodiment of the layer (100) of the present invention.

Fig. 2A: shows a cross sectional view of a schematic of one embodiment of the layer (100) of the present invention explaining possible setting up of an optical device with using said layer (100).

Fig. 2B: shows a cross sectional view of a schematic of another embodiment of the layer (100) of the present invention explaining possible setting up of an optical device with using said layer (100).

Fig. 3: shows a cross sectional view of a schematic of one embodiment of a multiple layer (300) of the invention.

Fig. 4: shows a cross sectional view of a schematic of one embodiment of a color conversion device (400) of the invention.

Fig. 5A: shows a cross sectional view of a schematic of one embodiment of an optical device (500) of the invention.

Fig. 5B: shows a cross sectional view of a schematic of one embodiment of an optical device (500) of the invention.

Fig. 6A: shows the results of the Cross Section SEM analysis of the Film A.

Fig. 6B: shows the results of the Cross Section SEM analysis of the Film B.

Fig. 7A: shows the results of the Cross Section SEM analysis of the Film C.

Fig. 7B: shows the results of the Cross Section SEM analysis of the Film D.

Fig. 8A: shows the results of the Cross Section SEM analysis of the Film E.

Fig. 8B: shows the results of the Cross Section SEM analysis of the Film F.

Fig. 9A: shows the Se profile of Film A cured at 2.3 $mW/cm^2$ for 10 min. Starting point of the EDS linescan is at silicone wafer, starting point of Film A is at 0.88 um.

Fig. 9B: shows the Se profile of Film B cured at 300 $mW/cm^2$ for 10 sec. Starting point of the EDS linescan is at silicone wafer, starting point of Film B is at 0.38 um.

List of reference signs in figure 1A

100. a layer (a cured composition film)
110. a matrix material
120. a light emitting moiety
130. a light scattering particle (optional)
140. the upper side
150. the lower side

List of reference signs in figure 1B

100. a layer (a cured composition film)
110. a matrix material
120. a light emitting moiety
130. a light scattering particle (optional)
140. the upper side
150. the lower side
210. a 1st phase
211. aggregates of the light emitting moieties
220. a 2nd phase

List of reference signs in figure 1C and 1D

100. a layer (a cured composition film)
110. a matrix material
120. a light emitting moiety
130. a light scattering particle (optional)
160. the area
170. the bottom side
180. the middle part
190. the top side
230. the top surface of the layer
240. the lower surface of the layer

List of reference signs in figure 2

100. a layer (a cured composition film)
110. a matrix material
120. a light emitting moiety
130. a light scattering particle (optional)
160. the area
170. the bottom side
180. the middle part
190. the top side
230. the top surface of the layer
240. the lower surface of the layer
250. light modulating / light emitting device (e.g. LCD, OLED)
251. light modulating / light emitting layer
252. an optical layer / substrate
253. an optical layer / substrate
254. light
260. an optical layer /substrate

List of reference signs in figure 3

300. a multiple layer
100. a layer (a cured composition film)
110. a matrix material
120. a light emitting moiety

130. a light scattering particle (optional)
160. the area
170. the bottom side
180. the middle part
190. the top side
230. the top surface of the layer
240. the lower surface of the layer
310. another layer

List of reference signs in figure 4

400. a color conversion device
100R. a layer (a cured composition film) for red color
100G. a layer (a cured composition film) for green color
110. a matrix material
120R. a red light emitting moiety
120G. a green light emitting moiety
130. a light scattering particle (optional)
160. the area
411. a 1st pixel (red)
412. a 2nd pixel (green)
413. a 3rd pixel (blue) (optional)
420. another layer
430. a bank
440. an optical layer / substrate
450R. a red dye (optional)
450G. a green dye (optional)
450B. a blue dye (optional)

List of reference signs in figure 5

500. an optical device
400. a color conversion device
100R. a layer (a cured composition film) for red color
100G. a layer (a cured composition film) for green color
110. a matrix material
120R. a red light emitting moiety
120G. a green light emitting moiety
130. a light scattering particle (optional)
160. the area
411. a 1st pixel (red)
412. a 2nd pixel (green)
413. a 3rd pixel (blue)
420. another layer
430. a bank
440. an optical layer / substrate
450R. a red dye (optional)
450G. a green dye (optional)
450B. a blue dye (optional)
510. a light modulating / light emitting device (e.g. LCD / OLED)
511. a TFT
512. an electrode (e.g. anode)
513. a substrate
514. an electrode (e.g. cathode)

515. light modulating / light emitting layer (e.g. LC layer / OLED layer(s))
516. light emission from a light emitting device (510)
520. an optical layer / substrate (optional)
530. a color filter (optional)
540. an optical layer (e.g. polarizer) (optional)

Definition of the terms

In the present specification, symbols, units, abbreviations, and terms have the following meanings unless otherwise specified.

In the present specification, unless otherwise specifically mentioned, the singular form includes the plural form and "one" or "that" means "at least one". In the present specification, unless otherwise specifically mentioned, an element of a concept can be expressed by a plurality of species, and when the amount (for example, wt. %, mass % or mol %) is described, it means sum of the plurality of species. "and/or" includes a combination of all elements and also includes single use of the element.

In the present specification, when a numerical range is indicated using "to" or " - ", it includes both endpoints and units thereof are common. For example, 5 to 25 mol % means 5 mol % or more and 25 mol % or less.

In the present specification, the hydrocarbon means one including carbon and hydrogen, and optionally including oxygen or nitrogen. The hydrocarbyl group means a monovalent or divalent or higher valent hydrocarbon. In the present specification, the aliphatic hydrocarbon means a linear, branched or cyclic aliphatic hydrocarbon, and the aliphatic hydrocarbon group means a monovalent or divalent or higher valent aliphatic hydrocarbon. The aromatic hydrocarbon means a hydrocarbon comprising an aromatic ring which may optionally not only comprise an aliphatic hydrocarbon group as a substituent but also be condensed with an alicycle. The aromatic hydrocarbon group means a monovalent or divalent or higher valent aromatic hydrocarbon. Further, the aromatic ring means a hydrocarbon comprising a conjugated unsaturated ring structure, and the alicycle means a hydrocarbon having a ring structure but comprising no conjugated unsaturated ring structure.

In the present specification, the alkyl means a group obtained by removing any one hydrogen from a linear or branched, saturated hydrocarbon and includes a linear alkyl and branched alkyl, and the cycloalkyl means a group obtained by removing one hydrogen from a saturated hydrocarbon comprising a cyclic structure and optionally includes a linear or branched alkyl in the cyclic structure as a side chain.

In the present specification, the aryl means a group obtained by removing any one hydrogen from an aromatic hydrocarbon. The alkylene means a group obtained by removing any two hydrogens from a linear or branched, saturated hydrocarbon. The arylene means a hydrocarbon group obtained by removing any two hydrogens from an aromatic hydrocarbon.

In the present specification, when polymer has a plural types of repeating units, these repeating units copolymerize. These copolymerization are any of alternating copolymerization, random copolymerization, block copolymerization, graft copolymerization, or a mixture of any of these.

According to the present invention, the term "(meth)acrylate polymer" means a methacrylate polymer, an acrylate polymer or a combination of methacrylate polymer and an acrylate polymer.

The term "emission" means the emission of electromagnetic waves by electron transitions in atoms and molecules.

In the present specification, Celsius is used as the temperature unit. For example, 20 degrees means 20 degrees Celsius.

Detailed description of the invention

According to the present invention, in one aspect, the layer (100) comprises, essentially consists of, or consists of, at least a matrix material (110) and one or more light emitting moieties (120), wherein the distribution of the light emitting moiety (120) in the layer is not identical in the direction of layer thickness, preferably the concentration of the light emitting moiety (120) in the layer varies in the direction of the layer thickness, more preferably the concentration of the light emitting moiety (120) in the layer varies from a low concentration on one side of the layer to an high concentration on the opposite side of the layer, preferably said one side is the upper side (140) of the layer or the lower side (150) of the layer, more preferably said one side is the upper side (140) of the layer, preferably the layer (100) contains a 1$^{st}$ phase (210) and a 2$^{nd}$ phase (220) as described below in the 2$^{nd}$ aspect and/or the concentration of the light emitting moieties is defined as described below in the 3$^{rd}$ and/or 4$^{th}$ aspect.

According to the present invention, in another (2$^{nd}$) aspect, the layer (100) comprises, essentially consists of, or consists of, at least a matrix material (110) and one or more light emitting moieties (120), contains a 1$^{st}$ phase (210) and a 2$^{nd}$ phase (220), wherein said 1$^{st}$ phase (210) and said 2$^{nd}$ phase (220) are different of each other and said 1$^{st}$ phase (210)

has a plurality of aggregates (211) of said light emitting moieties (120) and higher concentration of light emitting moieties per unit volume in the 1st phase (210) than the 2nd phase (220), preferably said unit volume is $1cm^3$, wherein the concentration of the 1st phase (210) in the layer varies from a low concentration on the one side of the layer to an high concentration on the opposite side of the layer, whereas the concentration of the 2nd phase (220) in the layer varies in contrary from a high concentration on the one side of the layer to a low concentration on the opposite side of the layer, preferably said one side is the upper side (140) of the layer or the lower side (150) of the layer, more preferably said one side is the upper side (140) of the layer, preferably the concentration of the light emitting moieties is additionally defined as described in the 3rd and/or 4th aspect.

Here the term "the lower side (150) of the layer" means the side of the layer which is configured to be set facing a light modulating or a light emitting device such as LCD / OLED when the layer is included in an optical device having said light modulating or said light emitting device.

Here the term "the upper side (140) of the layer" means the side of the layer which is opposite from the lower side (150) of the layer as described above.

According to the present invention, in another (3rd) aspect, the layer (100) comprises, essentially consists of, or consists of, at least a matrix material (110) and one or more light emitting moieties (120), wherein 30 wt% or more of the light emitting moieties (120) based on the total amount of the light emitting moieties in the layer are concentrated in an area (160) of the layer, wherein said area (160) has the thickness within 25% of the thickness of the layer; preferably the area (160) is placed at any point in the layer, more preferably said area (160) is placed in the bottom side (170) of the layer that is within 25% of the layer thickness from the bottom surface (240) of the layer to the top surface (230) of the layer, or middle part (180) of the layer that has the thickness within 25% of the layer thickness, or the top side (190) of the layer that is within 25% of the layer thickness from the top surface (230) of the layer to the bottom surface (240) of the layer, preferably the area (160) is placed in the bottom side (170) of the layer or in the top side of the layer, preferably from 30wt% to 70wt% of the light emitting moieties based on the total amount of the light emitting moieties in the layer (100) are concentrated in the area (160), more preferably 40 to 60wt%, preferably the concentration of the light emitting moieties is additionally defined as described in the 4th aspect.

According to the present invention, in another (4th) aspect, the layer (100) comprises, essentially consists of, or consists of, at least a matrix material (110) and one or more light emitting moieties (120), wherein 41 wt.% or more of the light emitting moieties (120) based on the total amount of the light emitting moieties in the layer are concentrated in the area (160) of the layer, wherein said area (160) has the thickness within 40% of the layer thickness of the layer; preferably the area (160) is placed at any point in the layer, more preferably said area (160) is placed in the bottom side (170) of the layer that is within 40% of the layer thickness from the bottom surface (240) of the layer to the top surface (230) of the layer, the top side (190) of the layer that is within 40% of the layer thickness from the top surface (230) of the layer to the bottom surface (240) of the layer or the middle part (180) of the layer that has the thickness within 40% of the layer thickness, preferably the area (160) is placed in the bottom side (170) of the layer or the top side (190) of the layer, preferably from 45wt% to 90wt% of the light emitting moieties based on the total amount of the light emitting moieties in the layer are concentrated in the area (160), more preferably 50 to 80wt%, preferably the concentration of the light emitting moieties is additionally defined as described in the 3rd aspect.

Here the term "the bottom surface (240) of the layer" means the surface of the layer which is configured to be set facing a light modulating or a light emitting device such as LCD / OLED when the layer is included in an optical device having said light modulating or said light emitting device.

Here the term "the top surface (230) of the layer" means the surface of the layer which is opposite from the bottom surface (240) of the layer as defined above.

In a preferred embodiment of the present invention, the layer thickness of the layer (100) is in the range from 1 to 50 $\mu$m, preferably 3 to 30, more preferably 6 to 20, furthermore preferably 8 to 15 um from the viewpoint of improved process ability, easy fabrication, lower consumption of materials used for fabrication of the film and improved optical properties of the film.

In a preferred embodiment of the present invention, the layer contains a plurality of light emitting moieties (120), preferably the total amount of the light emitting moieties is in the range from 0.1wt.% to 90wt.% based on the total amount of the composition, more preferably from 10wt.% to 70wt.%, even more preferably from 15wt.% to 60wt.%, from the view point of realizing claimed film structure/film morphology, higher EQE of the film, especially improved EQE with lower layer thickness, optimal dispersibility of the light emitting moiety in the film as described in the above mentioned aspects.

In a preferred embodiment of the present invention, the layer is configured to show the EQE value 25% or more, preferably 30% or more and less than 50%. Especially, the layer has the film structure/film morphology as described in the aspects above and it realizes the improved EQE value as described above.

- Matrix material (110)

In a preferable embodiment, the matrix material (110) contains, essentially consists of, or consists of a (meth)acrylate polymer, preferably it is a methacrylate polymer, an acrylate polymer or a combination of thereof, more preferably it is an acrylate polymer from the view point of realizing lower temperature fabrication process, avoiding process damage of the light emitting moiety, good compatibility with the light emitting moiety and their ligands.

In some embodiments of the present invention, said matrix material (110) is obtained or obtainable from a reactive monomer of a composition by curing it.

Said composition comprises at least;

i) a reactive monomer, said monomer is a (meth)acrylate monomer;
ii) a light emitting moiety; and optionally
iii) a chemical compound comprising at least one end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid group, preferably said group is a phosphate group, a phosphonate group, thiol group, primary amine group and a carboxyl group, more preferably it is a carboxyl group.

Preferably said matrix material (110) is obtained or obtainable from the composition containing at least one di-acrylate monomer, particularly preferably said matrix material (110) is obtained or obtainable from the composition containing at least one di-acrylate monomer and a mono-acrylate monomer, preferably said composition is a photosensitive composition. It is believed that the matrix material (110) made from the composition especially from the reactive monomer can realize the film morphology and it realizes higher EQE of the film.

Thus, the layer is made from a composition, preferably from a photocurable composition, comprising at least;

i) a reactive monomer, said monomer is a (meth)acrylate monomer;
ii) a light emitting moiety; and optionally
iii) a chemical compound comprising at least one end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid, preferably said group is a phosphate group, a phosphonate group, thiol group, tertiary amine group and a carboxyl group, more preferably it is a carboxyl group. Preferably said layer is made from the composition by curing the composition. Preferably the composition is cured by UV irradiation or heat treatment, more preferably the composition is cured by UV irradiation to obtain the film of the present invention.

It is believed that the matrix material (110) made from the composition especially from a reactive monomer can realize the film morphology and it realizes higher EQE of the film and/or blue shift of the peak maximum light wavelength of light emitted from the film.

- Light emitting moiety (120)

In a preferable embodiment of the present invention, said light emitting moiety is an organic and/or inorganic light emitting material, preferably it is an organic dye, inorganic phosphor and/or a semiconducting light emitting nanoparticle such as a quantum material.

In some embodiments of the present invention, the total amount of the light emitting moiety (120) is in the range from 0.1wt.% to 99wt.% based on the total amount of the composition / film or based on the total amount of the pixel, preferably said pixel is a 1$^{st}$ pixel (411) and/or a 2$^{nd}$ pixel (412), preferably from 10wt.% to 80wt.%, more preferably from 40wt.% to 60wt.%.

- Semiconducting light emitting nanoparticle

According to the present invention, the term "semiconductor" means a material that has electrical conductivity to a degree between that of a conductor (such as copper) and that of an insulator (such as glass) at room temperature. Preferably, a semiconductor is a material whose electrical conductivity increases with the temperature.

The term "nanosized" means the size in between 0.1 nm to 150 nm, more preferably 3nm to 50 nm.

Thus, according to the present invention, "semiconducting light emitting nanoparticle" is taken to mean that the light emitting material which size is in between 0.1nm to 150 nm, more preferably 3nm to 50nm, having electrical conductivity to a degree between that of a conductor (such as copper) and that of an insulator (such as glass) at room temperature, preferably, a semiconductor is a material whose electrical conductivity increases with the temperature, and the size is in between 0.1 nm and 150 nm, preferably 0.5 nm to 150 nm, more preferably 1 nm to 50 nm.

According to the present invention, the term "size" means the average diameter of a circle with an area equal to an

average area of dark contrast features in TEM image of the semiconducting nanosized light emitting particles.

The average diameter of the semiconducting nanosized light emitting particles is calculated based on 100 semiconducting light emitting nanoparticles in a TEM image created by a Tecnai G2 Spirit Twin T-12 Transmission Electron Microscope.

In a preferred embodiment of the present invention, the semiconducting light emitting nanoparticle of the present invention is a quantum sized material.

According to the present invention, the term "quantum sized" means the size of the semiconducting material itself without ligands or another surface modification, which can show the quantum confinement effect, like described in, for example, ISBN:978-3-662-44822-9.

For example, CdS, CdSe, CdTe, ZnS, ZnSe, ZnSeS, ZnTe, ZnO, GaAs, GaP, GaSb, HgS, HgSe, HgSe, HgTe, InAs, InP, InPZn, InPZnS, InPZnSe, InPZnSeS, InPZnGa, InPGaS, InPGaSe, InPGaSeS, InPZnGaSeS and InPGa, InCdP, InPCdS, InPCdSe, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$ alloys and a combination of any of these can be used.

In a preferred embodiment of the present invention, the 1st semiconducting material comprises at least one element of the group 13 of the periodic table, and one element of the group 15 of the periodic table, preferably the element of the group 13 is In, and the element of the group 15 is P, more preferably the 1st semiconducting material is selected from the group consisting of InP, InPZn, InPZnS, InPZnSe, InPZnSeS, InPZnGa, InPGaS, InPGaSe, InPGaSeS, InPZnGaSeS and InPGa.

According to the present invention, a type of shape of the core of the semiconducting light emitting nanoparticle, and shape of the semiconducting light emitting nanoparticle to be synthesized are not particularly limited.

For examples, spherical shaped, elongated shaped, star shaped, polyhedron shaped, pyramidal shaped, tetrapod shaped, tetrahedron shaped, platelet shaped, cone shaped, and irregular shaped core and - or a semiconducting light emitting nanoparticle can be synthesized.

In some embodiments of the present invention, the average size of the core is in the range from 1.5 nm to 3.5 nm.

The average diameter of the core is calculated based on 100 semiconducting light emitting nanoparticles in a TEM image created by a Tecnai G2 Spirit Twin T-12 Transmission Electron Microscope by measuring the longest axis of each single particles.

In some embodiments of the present invention, at least one shell layer comprises or consisting of a 1st element of group 12 of the periodic table and a 2nd element of group 16 of the periodic table, preferably, the 1st element is Zn, and the 2nd element is S, Se, or Te; preferably a first shell layer covering directly onto said core comprises or consisting of a 1st element of group 12 of the periodic table and a 2nd element of group 16 of the periodic table, preferably, the 1st element is Zn, and the 2nd element is S, Se, or Te.

In a preferred embodiment of the present invention, at least one shell layer (a first shell layer) is represented by following formula (XI), preferably the shell layer directly covering the core is represented by the chemical formula (XI);

$$ZnS_xSe_yTe_z - \qquad (XI)$$

wherein $0 \le x \le 1$, $0 \le y \le 1$, $0 \le z \le 1$, and $x+y+z=1$, preferably $0 \le x \le 1$, $0 \le y \le 1$, $z=0$, and $x+y=1$, preferably, the shell layer is ZnSe, ZnS, $ZnS_xSe_y$, $ZnSe_yTe_z$ or $ZnS_xTe_z$.

In some embodiments of the present invention, said shell layer is an alloyed shell layer or a graded shell layer, preferably said graded shell layer is $ZnS_xSe_y$, $ZnSe_yTe_z$, or $ZnS_xTe_z$, more preferably it is $ZnS_xSe_y$.

In some embodiments of the present invention, the semiconducting light emitting nanoparticle further comprises 2nd shell layer onto said shell layer, preferably the 2nd shell layer comprises or a consisting of a 3rd element of group 12 of the periodic table and a 4th element of group 16 of the periodic table, more preferably the 3rd element is Zn, and the 4th element is S, Se, or Te with the proviso that the 4th element and the 2nd element are not same.

In a preferred embodiment of the present invention, the 2nd shell layer is represented by following formula (XI'),

$$ZnS_xSe_yTe_z - \qquad (XI')$$

wherein $0 \le x \le 1$, $0 \le y \le 1$, $0 \le z \le 1$, and $x+y+z=1$, preferably, the shell layer is ZnSe, $ZnS_xSe_y$, $ZnSe_yTe_{z,}$ or $ZnS_xTe_z$ with the proviso that the shell layer and the 2nd shell layer is not the same.

In some embodiments of the present invention, said 2nd shell layer can be an alloyed shell layer.

In some embodiments of the present invention, the semiconducting light emitting nanoparticle can further comprise one or more additional shell layers onto the 2nd shell layer as a multishell.

According to the present invention, the term "multishell" stands for the stacked shell layers consisting of three or more shell layers.

For example, CdSe/CdS, CdSeS/CdZnS, CdSeS/CdS/ZnS, ZnSe/CdS, CdSe/ZnS, InP/ZnS, InP/ZnSe, In-P/ZnSe/ZnS, InZnP /ZnS, InZnP /ZnSe, InZnP /ZnSe/ZnS, InGaP/ZnS, InGaP/ZnSe, InGaP/ZnSe/ZnS, InZnPS/ ZnS,

InZnPS ZnSe, InZnPS /ZnSe/ZnS, ZnSe/CdS, ZnSe/ZnS or combination of any of these, can be used. Preferably, InP/ZnS, InP/ZnSe, InP/ZnSe/ZnS, InZnP /ZnS, InZnP /ZnSe, InZnP /ZnSe/ZnS, InGaP/ZnS, InGaP/ZnSe, InGaP/ZnSe/ZnS.

Such semiconducting light emitting nanoparticles are publicly available (for example from Sigma Aldrich) and / or can be synthesized with the method described for example in US 7,588,828 B, US 8,679,543 B and Chem. Mater. 2015, 27, pp 4893-4898.

In some embodiments of the present invention, the composition comprises two or more semiconducting light emitting nanoparticles.

In some embodiments of the present invention, the layer comprises a plurality of light emitting moiety.

In some embodiments of the present invention, the total amount of the light emitting moiety in the layer is in the range from 0.1wt.% to 90wt.% based on the total amount of the layer, preferably from 10wt.% to 70wt.%, more preferably from 30wt.% to 60wt.%.

- Ligands

In some embodiments of the present invention, optionally, the light emitting moiety can be directly over coated by one or more ligands, or the outer most surface of the inorganic part of the semiconducting light emitting nanoparticle can be directly coated by the ligands. As an option, ligand coated semiconducting light emitting nanoparticle can be overcoated by a polymer forming a polymer beads having said semiconducting light emitting nanoparticle(s) inside.

As the ligands, phosphines and phosphine oxides such as Trioctylphosphine oxide (TOPO), Trioctylphosphine (TOP), and Tributylphosphine (TBP); phosphonic acids such as Dodecylphosphonic acid (DDPA), Tridecylphosphonic acid (TDPA), Octadecylphosphonic acid (ODPA), and Hexylphosphonic acid (HPA); amines such as Oleylamine, Dodecyl amine (DDA), Tetradecyl amine (TDA), Hexadecyl amine (HDA), and Octadecyl amine (ODA), Oleylamine (OLA), 1-Octadecene (ODE), thiols such as hexadecane thiol, dodecane thiol and hexane thiol; mercapto carboxylic acids such as mercapto propionic acid and mercaptoundecanoic acid; carboxylic acids such as oleic acid, stearic acid, myristic acid; acetic acid, branched nonanoic acid, Polyethylenimine (PEI), monofunctional polyethylene glycol PEG thiol (mPEG-thiol) or a derivatives of mPEG thiol, PEG carboxylate and a combination of any of these can be used .

Examples of such ligands have been described in, for example, the laid-open international patent application No. WO 2012/059931A.

i) Reactive monomer

It is believed that the lower viscosity is important to make a low viscosity composition suitable for inkjet printing. Therefore, a (meth)acrylate monomer having the viscosity value 35 cP or less at room temperature, preferably in the range from 1 to 35 cP, more preferably from 2 to 30 cP, even more preferably from 2 to 25 cP is especially suitable to make a composition for inkjet printing. By using these (meth)acrylate monomer in a composition, when it is mixed with another material such as semiconducting light emitting nanoparticles with high loading, the composition can still keep lower viscosity within the range suitable for inkjet printing.

In a preferred embodiment of the present invention, the boiling point (B.P.) of said reactive monomer is 80°C or more, preferably it is in the range from 80°C to 400°C, even more preferably from 85°C to 375°C, further more preferably from 90°C to 350°C for large area uniform inkjet printing.

Here, the term "(meth)acrylate" is a general term for an acrylate and a methacrylate. Therefore, accroding to the present invention, the term "(meth)acrylate monomer" means a methacrylate monomer and/or a acrylate monomer.

According to the present invention, said B.P can be estimate by the known method such as like described in Science of Petroleum, Vol.II. p.1281 (1398).

According to the present invention, any types of publicly available acrylates and /or methacrylates represented by chemical formula (I) or (II) can be used preferably.

Especially for the first aspect, any types of publicly available acrylates and / or methacrylates having the viscosity value of 25 cP or less at 25°C represented by chemical formula (I), (II) and/or (III) can be used preferably.

Thus, according to the present invention, the reactive monomer of the composition is preferably a (meth)acrylate monomer selected from a mono-(meth)acrylate monomer, a di-(meth)acrylate monomer or a tri-(meth)acrylate monomer more preferably it is a di-methacrylate monomer or a di-acrylate monomer, tri-methacrylate monomer, tri-acrylate monomer, even more preferably it is represented by following chemical formula (II);

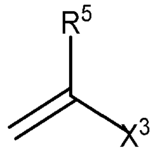

(II)

$X^3$ is a non-substituted or substituted alkyl group, aryl group or an alkoxy group;

preferably the symbol $X^3$ is

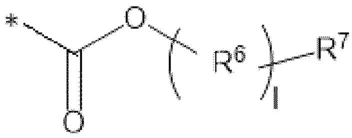

,

where "*" on the left side of the formula represents the connecting point to the end group $C=CR^5$ of the formula (I);

I is 0 or 1 ;

$R^5$ is a hydrogen atom, halogen atom of Cl, Br, or F, methyl group, alkyl group, aryl group, alkoxy group, ester group, or a carboxylic acid group;

$R^6$ is a straight alkylene chain or alkoxylene chain having 1 to 25 carbon atoms, preferably $R^6$ is a straight alkylene chain or alkoxylene chain having 1 to 15 carbon atoms, more preferably 1 to 5 carbon atoms,

which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^7$ is a straight alkyl chain or alkoxyl chain having 1 to 25 carbon atoms, preferably $R^7$ is a straight alkyl chain or alkoxyl chain having 1 to 15 carbon atoms, more preferably 1 to 5 carbon atoms, which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another.

The composition further comprises a (meth)acrylate monomer represented by following chemical formula (I) and/or a (meth)acrylate monomer represented by following chemical formula (III);

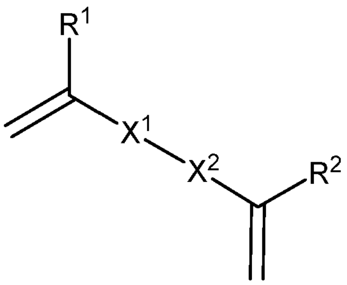

(I)

wherein

$X^1$ is a non-substituted or substituted alkyl group, aryl group or an alkoxy group or an ester group;

$X^2$ is a non-substituted or substituted alkyl group, aryl group or an alkoxy group or an ester group;

$R^1$ is a hydrogen atom, halogen atom of Cl, Br, or F, methyl group, alkyl group, aryl group, alkoxy group, ester group, or a carboxylic acid group;

$R^2$ is a hydrogen atom, halogen atom of Cl, Br, or F, methyl group, alkyl group, aryl group, alkoxy group, ester group, or a carboxylic acid group;

preferably the symbol $X^1$ is

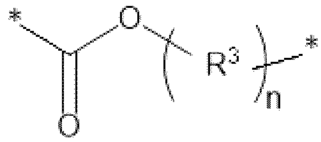

,

where "*" on the left side of the formula represents the connecting point to the carbon atom of the end group $C=CR^1$ of the formula (I) and "*" on the right side represents the connecting point to symbol $X^2$ of the formula (I);

n is 0 or 1;

preferably the symbol $X^2$ is

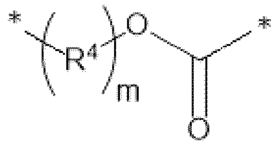

,

where "*" on the left side of the formula represents the connecting point to symbol X1 of the formula (I) and "*" on the right side represents the connecting point to the end group $C=CR^2$ of the formula (I); m is 0 or 1;

preferably at least m or n is 1;

$R^3$ is a straight or branched alkylene chain or alkoxylene chain having 1 to 25 carbon atoms, a cycloalkane having 3 to 25 carbon atoms or an aryl group having 3 to 25 carbon atoms, preferably $R^3$ is a straight or branched alkylene chain or alkoxylene chain having1 to 15 carbon atoms, more preferably 1 to 5 carbon atoms,

which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^4$ is a straight or branched alkylene chain or alkoxylene chain having 1 to 25 carbon atoms, a cycloalkane having 3 to 25 carbon atoms or an aryl group having 3 to 25 carbon atoms, preferably $R^4$ is a straight or branched alkylene chain or alkoxylene chain having1 to 15 carbon atoms, more preferably 1 to 5 carbon atoms,

which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system

with one another;

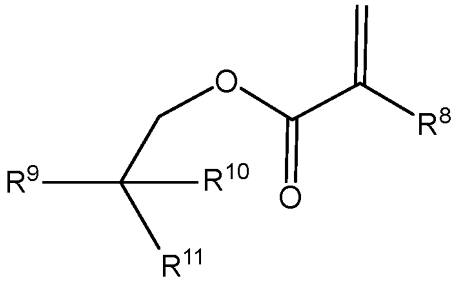

(III);

wherein $R^9$ is hydrogen atom, a straight alkyl group having 1 to 25 carbon atoms or a (meth)acryl group represented by chemical formula (IV)

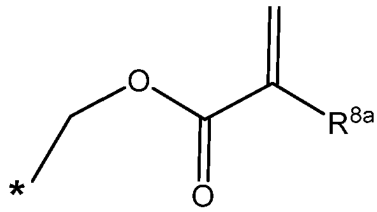

(IV);

$R^{10}$ is hydrogen atom, a straight alkyl group having 1 to 25 carbon atoms or a (meth)acryl group represented by chemical formula (V)

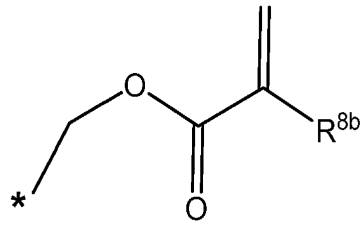

(V);

$R^{11}$ is hydrogen atom, a straight alkyl group having 1 to 25 carbon atoms or a (meth)acryl group represented by chemical formula (VI)

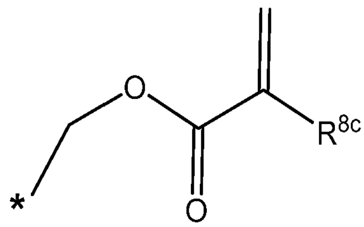

(VI);

wherein $R^8$, $R^{8a}$, $R^{8b}$ and $R^{8c}$ are, each independently or dependently of each other at each occurrence, H, $CH_2CH_3$ or $CH_3$;

wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms, preferably the electric conductivity (S/cm) of the (meth)acrylate monomer of formula (III) is $1.0*10^{-10}$ or less, preferably it is $5.0*10^{-11}$ or less, more preferably it is in the range from $5.0*10^{-11}$ to $1.0*10^{-15}$, even more preferably it is in the range from $5.0*10^{-12}$ to $1.0*10^{-15}$

In a preferred embodiment of the present invention, the (meth)acrylate monomer of chemical formula (II) is in the composition and the mixing ratio of the (meth)acrylate monomer of chemical formula (I) to the (meth)acrylate monomer of chemical formula (II) is in the range from 1:99 to 99:1 (formula (I) : formula (II)), preferably from 5:95 to 50:50, more preferably from 10:90 to 40:60, even more preferably it is from 15:85 to 35:65, preferably at least a purified (meth)acrylate monomer represented by chemical formula (I), (II) is used in the composition, more preferably the (meth)acrylate monomer of chemical formula (I) and the (meth)acrylate monomer of chemical formula (II) are both obtained or obtainable by a purification method.

In a preferred embodiment, the boiling point (B.P.) of said (meth)acrylate monomer of chemical formula (I) and/or chemical formula (II) is 80°C or more, preferably it is in the range from 80°C to 400°C, even more preferably from 85°C to 375°C, further more preferably from 100°C to 350°C. for large area uniform inkjet printing.

In a preferred embodiment of the present invention, the viscosity of the composition is 35 cP or less at 25°C, preferably in the range from 1 to 35 cP, more preferably from 2 to 30 cP, even more preferably from 2 to 25 cP.

According to the present invention, said viscosity can be measured by rheometer Kinexus Ultra+ (Netzsch) at room temperature. https://www.netzsch-thermal-analysis.com/en/products-solutions/rheology/kinexus-ultra/

- (Meth)acrylate monomer represented by chemical formula (I) as a matrix material

Furthermore preferably, said $R^3$ of formula (I) and $R^4$ of formula (I) are, each independently of each other, selected from the following groups.

| | | |
|---|---|---|
| $*-(CH_2)_1-*$ | $*-(CH_2)_2-*$ | $*-(CH_2)_3-*$ |
| $*-(CH_2)_4-*$ | $*-(CH_2)_5-*$ | $*-(CH_2)_6-*$ |
| $*-(CH_2)_7-*$ | 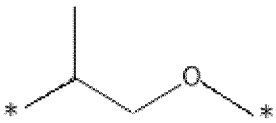 | 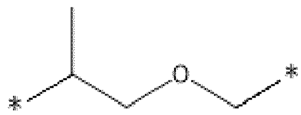 |
| 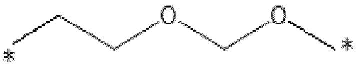 | 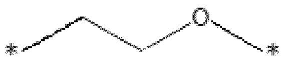 | 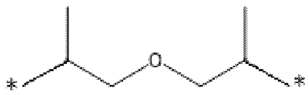 |
| 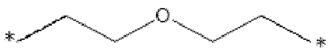 | 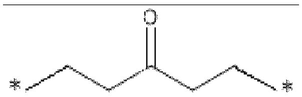 | 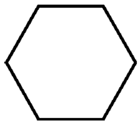 |
| 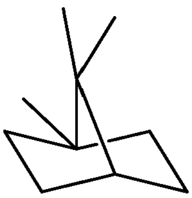 | 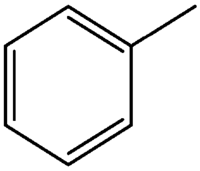 | 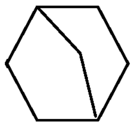 |
| 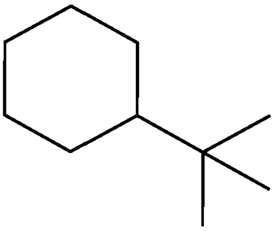 | 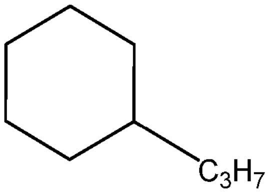 | 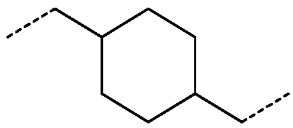 |
| 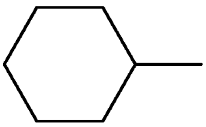 | 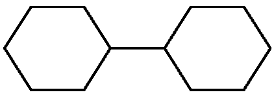 | 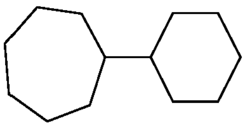 |

(continued)

| | | |
|---|---|---|
| 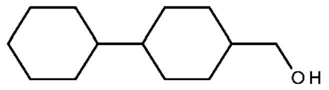 | 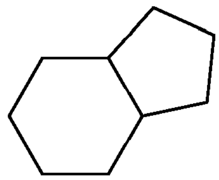 | 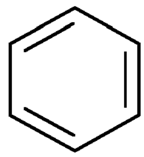 |
| 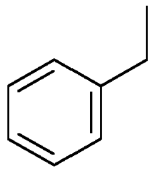 | 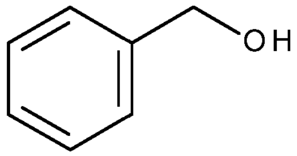 | 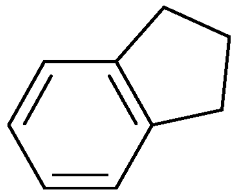 |
| 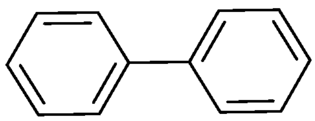 | 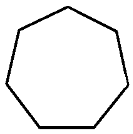 | 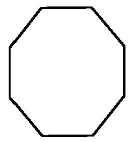 |
| 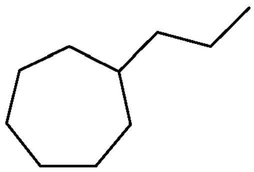 | 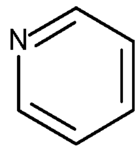 | 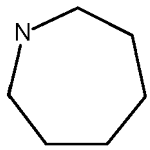 |
| 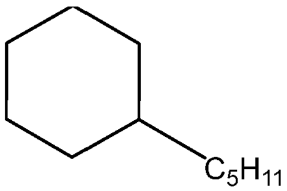 | | |

Particularly preferably, said $R^3$ and $R^4$ of formula (I) are, at each occurrence, independently or differently, selected from the following groups.

| | | |
|---|---|---|
| $*-(CH_2)_1-*$ | $*-(CH_2)_2-*$ | $*-(CH_2)_3-*$ |
| $*-(CH_2)_4-*$ | $*-(CH_2)_5-*$ | $*-(CH_2)_6-*$ |
| $*-(CH_2)_7-*$ | 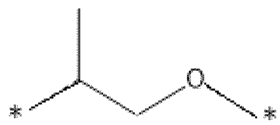 | 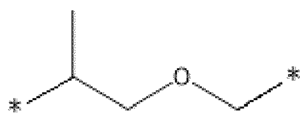 |
| 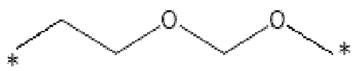 | 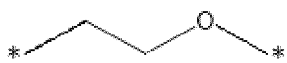 | 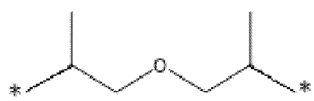 |

wherein "*" represents the connecting point to oxygen atom of the formula or the connecting point to $X^2$ of the formula in case of $R^3$, and wherein "*" represents the connecting point to oxygen atom of the formula or the connecting point to $X^1$ of the formula in case of $R^4$.

Furthermore preferably, said formula (I) is NDDA (nonanediol diacrylate; BP:342°C), HDDMA (hexanediol dimethacrylate; BP:307), HDDA (hexanediol diacrylate; BP:295°C ) or DPGDA (BP: 314°C).

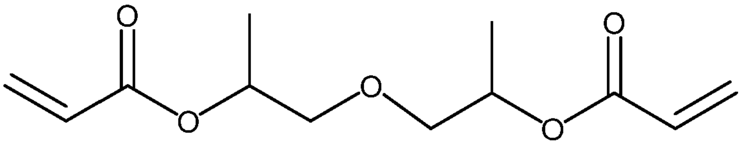

(DPGDA)

- (Meth)acrylate monomer represented by chemical formula (II)

It is believed that the (meth)acrylate monomer represented by following chemical formula (II) shows much lower viscosity value than the viscosity of the (meth)acrylate monomer of formula (I). Thus, by using the (meth)acrylate monomer represented by chemical formula (II) in combination of the (meth)acrylate monomer of chemical formula (I), a composition having much lower viscosity desirable for smooth inkjet printing can be realized, preferably without decreasing External Quantum Efficiency (EQE) value.

It is believed that said combination can realize a low viscosity composition comprising high amount of another materials, such as high loading of semiconducting light emitting nanoparticles. Thus, it is especially suitable for an inkjet printing when the composition comprises another material.

Furthermore preferably, said $R^7$ of formula (II) is, at each occurrence, independently or differently, selected from the following groups.

| | | |
|---|---|---|
| $*-(CH_2)_6-CH_3$ | $*-(CH_2)_7-CH_3$ | $*-(CH_2)_8-CH_3$ |
| $*-(CH_2)_9-CH_3$ | $*-(CH_2)_{10}-CH_3$ | $*-(CH_2)_{11}-CH_3$ |
| $*-(CH_2)_{12}-CH_3$ | $*-(CH_2)_4-OH$ | $*-(CH_2)_2-OH$ |
| $*-(CH_2)_6-OH$ | $*-(CH_2)_3-OH$ | $*-(CH_2)_5-OH$ |

**wherein** "*" represents the connecting point to $R^6$ of $X^3$ in case l is 1, and it is representing the connecting point to oxygen atom of $X^3$ of the formula (II) in case n is 0.

The furthermore preferably, said formula (II) is Lauryl methacrylate (LM, viscosity 6 cP, BP: 142°C) or Lauryl acrylate (LA, viscosity: 4.0cP, BP: 313.2°C).

It is believed that the higher amount of the (meth)acrylate monomer of chemical formula (II) to the total amount of the (meth)acrylate monomer of chemical formula (I) leads improved EQE of the composition, and the mixing weight ratio of the (meth)acrylate monomer of chemical formula (II) to the total amount of the (meth)acrylate monomer of chemical formula (I) less than 50 wt.% is preferable from the view point of viscosity of the composition, better ink-jetting properties of the composition.

Preferably, (meth)acrylate monomers purified by using silica column are used.

It is believed that an impurity removal from the (meth)acrylate monomers by the silica column purification leads improved QY of the semiconducting light emitting nanoparticle in the composition.

- (meth)acrylate monomer of chemical formula (II I)

It is believed that the (meth)acrylate monomer of chemical formula (III) is useful to improve solidity of a later made from the composition after inkjet printing.

According to the present invention, a publicly known (meth)acrylate monomer represented by following chemical formula (III) can be used to improve solidity of the layer after inkjet printing and cross linking.

Very preferably, Trimethylolpropane Triacrylate (TMPTA) is used as the (meth)acrylate monomer of chemical formula (III).

In a preferable embodiment of the present invention, the amount of the (meth)acrylate monomer of chemical formula (III) based on the total amount of (meth)acrylate monomers in the composition is in the range from 0.001 wt.% to 25wt.%, more preferably in the range from 0.1wt.% to 15wt.%, even more preferably from 1wt.% to 10wt.%, further more preferably from 3 to 7wt%.

Preferably, there (meth)acrylate monomers are purified by using silica column, are used.

It is believed that an impurity removal from the (meth)acrylate monomers by the silica column purification leads improved QY of the semiconducting light emitting nanoparticle in the composition.

According to the present invention, preferably the composition is configured to show the EQE value 20% or more, preferably 30% or more, even more preferably 33% or more and less than 50%.

According to the present invention, said EQE is measured by the following EQE measurement process at room

temperature which is based on using an integrating sphere, equipped with a 450nm excitation light source coupled in via an optical fiber, and a spectrometer (Compass X, BWTEK), and which consists of a first measurement using air as the reference to detect the incident photons of the excitation light and a second measurement with the sample or test cell placed in front of the integrating sphere in between the opening of the integrating sphere and the exit of the optical fiber to detect the photons incident from the excitation light source transmitted through the sample and the photos emitted from the sample or test cell, whereas for both cases photons exiting the integrating sphere are counted by the spectrometer and EQE and BL calculation is done with the following equations and the number of photons of the excitation light and emission light is calculated by integration over the following wavelength ranges;

EQE = Photons [Emission light] / Photons [Excitation light measured without sample in place];

BL = Photons [Excitation light measured with sample in place] / Photons [Excitation light measured without sample in place];

Emission light if green light emitting moieties are used: 490nm-600nm,
Emission light if red light emitting moieties are used: 560nm-780nm
Excitation light: 390nm-490nm .

-A chemical compound as an additive

In a preferred embodiment of the present invention, the composition and resulted layer (100) made from the composition may further contain a chemical compound represented by following chemical formula ($X^A$) or chemical formula ($I^A$).

Z(-X)u-Y - ($X^A$)

wherein

Z is *- $R^{x1}$ or

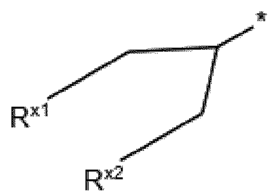

,

where "*" represents the connecting point to symbol Y of the formula, $R^{x1}$ is a group selected from one or more members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid, preferably said group is a phosphonate group, thiol group, primary amine group, a carboxyl group or a combination of any of these, more preferably it is a carboxyl group; and

$R^{x2}$ is a group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid, preferably said group is a phosphonate group, thiol group, primary amine group, a carboxyl group or a combination of any of these, more preferably it is a carboxyl group;

X is a single bond, an alkylene group having 1 to 15 carbon atoms, or an alkenylene group having 1 to 15 carbon atoms, or (poly)alkoxylene group having 1 to 15 carbon atoms, preferably Y is an (poly)alkoxylene group having 1 to 15 carbon atoms;

u is 0 or 1;

Y is a selected from unsaturated straight-chain alkyl group having carbon atoms 1 to 45, unsaturated or saturated branched chain alkyl group having carbon atoms 3 to 45, unsaturated or saturated straight-chain alkyl group having carbon atoms 1 to 80, preferably it is 8 to 70, more preferably 12 to 60, where one or more non-adjacent $CH_2$ groups is replaced by oxygen atom, C=O, C=S, C=Se, C=NH, $SiH_2$, SO, $SO_2$, OS, or CONH and where one or more H atoms may be replaced by D, F, Cl, Br, I, CN or $NO_2$, preferably one or more non-adjacent $CH_2$ groups is replaced by oxygen atom; straight-chain alkenyl group having carbon atoms 2 to 45, branched chain alkenyl group having carbon atoms 3 to 45, unsaturated or saturated straight-chain or branched chain alkoxyl group having carbon atoms 1 to 45, unsaturated or saturated straight chain aryl-alkyl group having carbon atoms 4 to 45, unsaturated or saturated branched chain aryl-alkyl group having carbon atoms 6 to 45, straight-chain aryl-alkenyl group having carbon atoms 5 to 45, branched chain aryl-alkenyl group having carbon atoms 6 to 45, unsaturated or saturated straight-chain aryl-alkoxyl group having carbon atoms 5 to 45, unsaturated or saturated branched-chain aryl-alkoxyl group having carbon atoms 5 to 45, unsaturated or saturated cyclo-alkyl group having carbon atoms 4 to 45, cyclo-alkenyl group having carbon atoms 4 to 45, unsaturated or saturated cyclo-alkoxyl group having carbon atoms 4 to 45;

preferably said group is selected from unsaturated straight-chain alkyl group having carbon atoms 1 to 45, unsaturated or saturated branched chain alkyl group having carbon atoms 3 to 45, straight-chain alkenyl group having carbon atoms 2 to 45, branched chain alkenyl group having carbon atoms 3 to 45, unsaturated or saturated straight-chain or branched chain alkoxyl group having carbon atoms 1 to 45, unsaturated or saturated straight-chain alkyl group having carbon atoms 1 to 80, preferably it is 8 to 70, more preferably 12 to 60, where one or more non-adjacent $CH_2$ groups is replaced by oxygen atom, C=O, C=S, C=Se, C=NH, $SiH_2$, SO, $SO_2$, OS, or CONH and where one or more H atoms may be replaced by D, F, Cl, Br, I, CN or $NO_2$, preferably one or more non-adjacent $CH_2$ groups is replaced by oxygen atom;

more preferably it is selected from unsaturated or saturated branched chain alkyl group having carbon atoms 3 to 45 or unsaturated or saturated straight-chain alkyl group having carbon atoms 1 to 80, preferably it is 8 to 70, more preferably 12 to 60, where one or more non-adjacent $CH_2$ groups is replaced by oxygen atom, C=O, C=S, C=Se, C=NH, $SiH_2$, SO, $SO_2$, OS, or CONH and where one or more H atoms may be replaced by D, F, Cl, Br, I, CN or $NO_2$, preferably one or more non-adjacent $CH_2$ groups is replaced by oxygen atom;

preferably said carbon atoms of the alkyl group, the alkenyl group and/or the alkoxy group are in the range from 10 to 35, more preferably it is from 14 to 30,

furthermore preferably it is an unsaturated or saturated straight-chain alkyl group having carbon atoms 1 to 80, preferably it is 8 to 70, more preferably 12 to 60, where one or more non-adjacent $CH_2$ groups is replaced by oxygen atom, C=O, C=S, C=Se, C=NH, $SiH_2$, SO, $SO_2$, OS, or CONH and where one or more H atoms may be replaced by D, F, Cl, Br, I, CN or $NO_2$, preferably one or more non-adjacent $CH_2$ groups is replaced by oxygen atom;

preferably said chain contains 1 to 5 carbon-carbon double bonds, more preferably 1 to 3 carbon-carbon double bonds, even more preferably 2 carbon-carbon double bonds,

said alkyl group, alkenyl group and/or alkoxy group, may optionally be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, C=S, C=Se, $C=NR^a$, $P(=O)(R^a)$, SO, $SO_2$, $NR^a$, OS, or $CONR^a$ and where one or more H atoms may be replaced by D, F, Cl, Br, I, CN or $NO_2$, preferably Y is a straight-chain or branched alkyl group,

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another;

In case Y is an unsaturated or saturated straight-chain alkyl group having carbon atoms 1 to 80, preferably it is 8 to 70, more preferably 12 to 60, where one or more non-adjacent $CH_2$ groups is replaced by oxygen atom, C=O, C=S, C=Se, C=NH, $SiH_2$, SO, $SO_2$, OS, or CONH and where one or more H atoms may be replaced by D, F, Cl, Br, I, CN or $NO_2$, preferably one or more non-adjacent $CH_2$ groups is replaced by oxygen atom, preferably u is 1 and Y is represented by the following formula,

$$*\text{-}[CH(R^1)\text{-}CH(R^2)\text{-}Q]_x\text{-}R^3,$$

wherein R' is H or an alkyl group having carbon atoms 1 to 5, preferably said alkyl group is an methyl group; $R^2$ is H or an alkyl group having carbon atoms 1 to 5, preferably said alkyl group is an methyl group, Q is an oxygen atom, nitrogen atom or sulfur atom, preferably Q is an oxygen atom; $R^3$ is H or a methyl group, x is an integer, preferably x is in the range from 1 to 300, more preferably from 2 to 200, even more preferably from 4 to 100, where "*" represents the connecting point to symbol X of the formula;
or

$$*-[(CHR^1)_n-Q)]_x-R^3$$

wherein n is 2 or 3, Q is an oxygen atom, nitrogen atom or sulfur atom, preferably Q is an oxygen atom, R' is H or a methyl group, $R^3$ is H or a methyl group, n is 1 to 5, preferably 1 to 3, more preferably n is 2, x is an integer, preferably x is in the range from 1 to 300, more preferably from 2 to 200, even more preferably from 4 to 100, where "*" represents the connecting point to symbol X of the formula, and

preferably wherein Z represents an attaching group comprising one or two S atoms or Z is a carboxyl group, preferably Z is

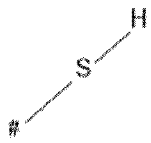 , 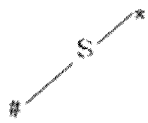 , 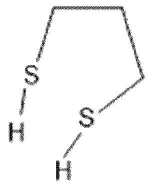 or 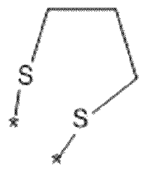 ,

more preferably

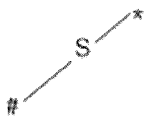 or 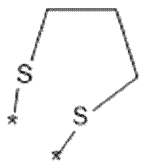 ,

where "#" represents the connecting point to group X, and "*" represents the connecting point to the surface of the light emitting moiety.

It is believed that said weight ratio of the chemical compound is very preferable to control viscosity/solubility of the composition accrodingly. And it is very preferable to prevent increasement of visicosity of the composition and/or keeping a good solubility of the light luminescent moietys in a long term strage in the composition.
As such a chemical compound, publicly known compounds satisfying the condition described above can be used preferably. For examples, mPEG-SH, elaidic acid, isostearic acid, linoleic acid can be used more preferably.
In some embodiments, as indicated above, the chemical compound can be represented by following chemical formula ($I^A$);

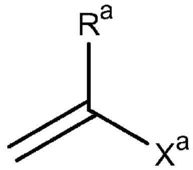 - ($I^A$)

wherein

the symbol $X^a$ is

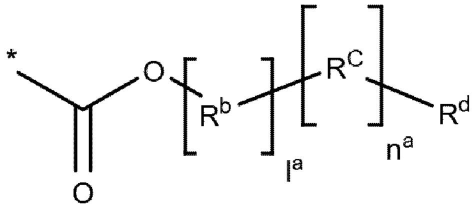

where "*" on the left side of the formula represents the connecting point to the end group of the formula ($I^A$); $1 \le l^a \le 20$, $1 \le n^a \le 10$, preferably $2 \le l^a \le 15$, $1 \le n^a \le 3$, more preferably $3 \le l^a \le 8$, $n^a$ is 1 or 2;

$R^a$ is a hydrogen atom, halogen atom of Cl, Br, or F, methyl group, alkyl group, aryl group, alkoxy group, ester group, or a carboxylic acid group, preferably $R^a$ is a hydrogen atom or methyl group; $R^b$ is an unsaturated or saturated straight alkylene group having 1 to 25 carbon atoms or an unsaturated or saturated branched alkylene group having 3 to 25 carbon atoms, preferably $R^b$ is an unsaturated or saturated straight or branched alkylene group having 3 to 15 carbon atoms, more preferably 3 to 10 carbon atoms, even more preferably 3 to 5 carbon atoms,

where one or more non-adjacent $CH_2$ groups may be replaced by $R^iC{=}CR^i$, C=C, $Si(R^i)_2$, $Ge(R^i)_2$, $Sn(R^i)_2$, O, C=O, C=S, C=Se, $C{=}NR^i$, $P({=}O)(R^i)$, SO, $SO_2$, $NR^i$, OS, or $CONR^i$ and where one or more H atoms may be replaced by D, F, Cl, Br, I, CN or $NO_2$; preferably one or more non-adjacent $CH_2$ groups of $R^b$ are replaced by oxygen atom;

$R^c$ is an unsaturated or saturated straight or branched alkylene chain having 1 to 25 carbon atoms, preferably $R^c$ is an unsaturated or saturated straight or branched alkylene chain having 2 to 15 carbon atoms, more preferably 2 to 6 carbon atoms,

where one or more non-adjacent $CH_2$ groups of $R^c$ may be replaced by $R^iC{=}CR^i$, C=C, $Si(R^i)_2$, $Ge(R^i)_2$, $Sn(R^i)_2$, O, C=O, C=S, C=Se, $C{=}NR^i$, $P({=}O)(R^i)$, SO, $SO_2$, $NR^i$, OS, or $CONR^i$ and where one or more H atoms may be replaced by D, F, Cl, Br, I, CN or $NO_2$; more preferably $R^c$ is represented by following chemical formula

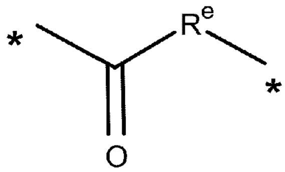

where "*" on the left side of the formula represents the connecting point to $R^b$ of the formula ($I^A$) and "*" on the right side of the formula represents the connecting point to $R^d$ of the formula ($I^A$);

$R^e$ is an unsaturated or saturated straight or branched alkylene chain having 2 to 15 carbon atoms, more preferably 2 to 5 carbon atoms,

where one or more non-adjacent $CH_2$ groups of $R^c$ may be replaced by $R^aC{=}CR^a$, C=C, $Si(R^i)_2$, $Ge(R^i)_2$, $Sn(R^i)_2$, O, C=O, C=S, C=Se, $C{=}NR^i$, $P({=}O)(R^i)$, SO, $SO_2$, $NR^i$, OS, or $CONR^i$ and where one or more H atoms may be replaced by D, F, Cl, Br, I, CN or $NO_2$;

$R^i$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another;

$R^d$ is an end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid, preferably said group is a phosphate group, a phosphonate group, thiol group, primary amine group and a carboxyl group, more preferably it is a carboxyl group.

As such chemical compound represented by chemical formula ($I^A$), following chemical compound and its derivatives can be used preferably.

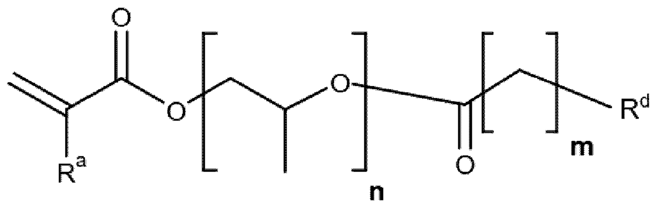

n = 1 to 15, m=2 to 15,

$R^a$ is a hydrogen atom, halogen atom of Cl, Br, or F, methyl group, alkyl group, aryl group, alkoxy group, ester group, or a carboxylic acid group, preferably $R^a$ is a hydrogen atom or methyl group;

$R^d$ is an end group selected from phosphine group, phosphine oxide group, phosphate group, phosphonate group, thiol group, tertiary amine, primary amine group, carboxyl group, hetero cyclic group, silane group, sulfonic acid, hydroxyl group, phosphonic acid, preferably said group is a phosphate group, a phosphonate group, thiol group, primary amine group or a carboxyl group, more preferably it is a carboxyl group.

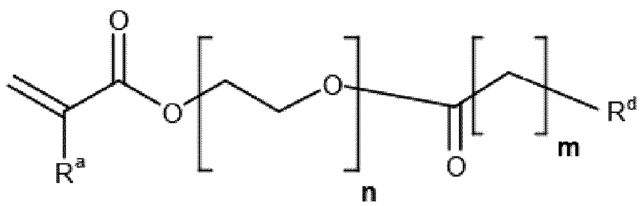

n, m and $R^a$ are as defined above.

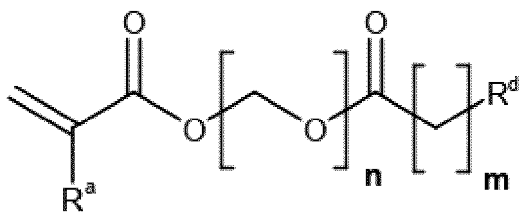

,

n, m and $R^a$ are as defined above.

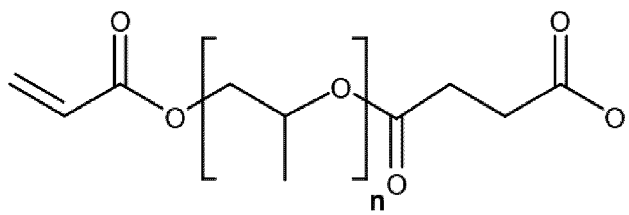

n = 1 to 15

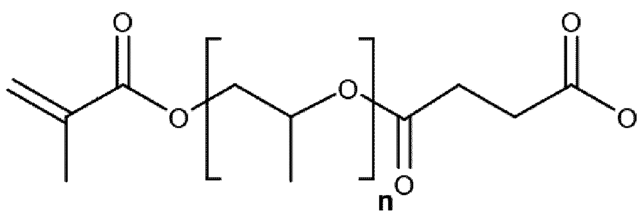

n = 1 to 15

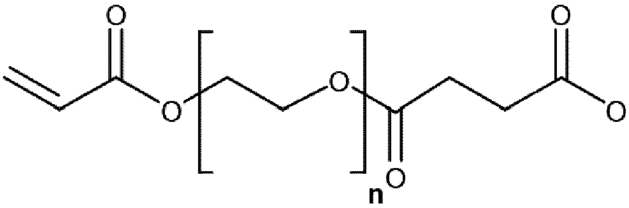

n = 1 to 15

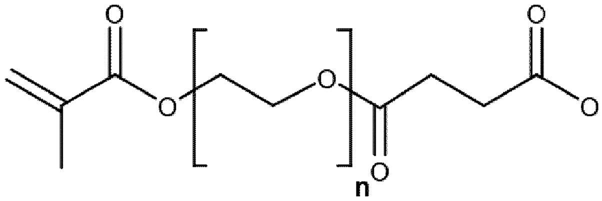

n = 1 to 15

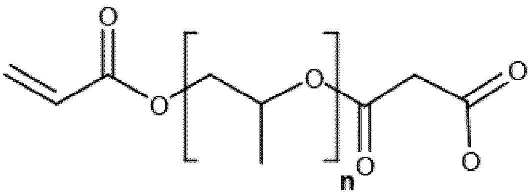

n = 1 to 15

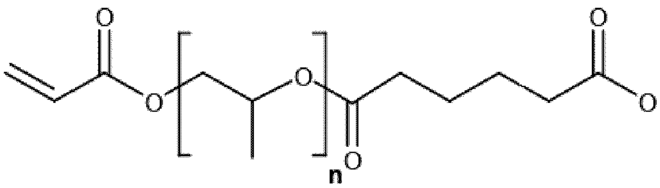

n = 1 to 15

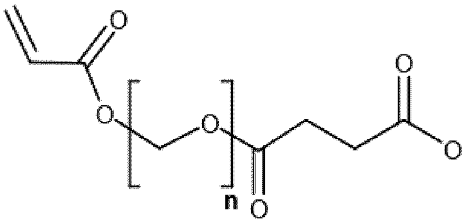

n = 1 to 15

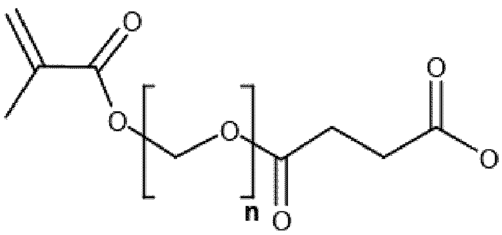

n = 1 to 15

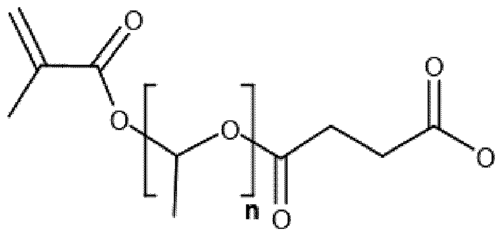

n = 1 to 15

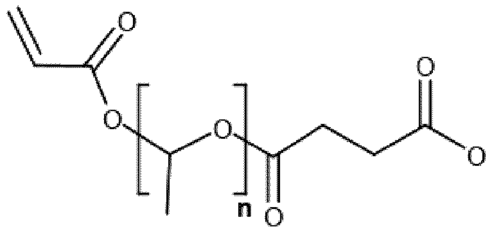

n = 1 to 15

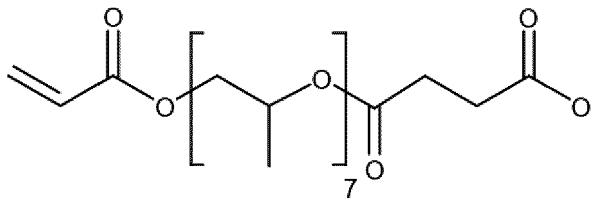

Compound L1

Fabrication process of the chemical compound is not particularly limited.

Publicly know process can be used preferably.

For examples, as a fabrication process of the chemical compound L1, following process can be used.

Preparation of chemical compound L1

Reactants:

| Name | CAS | Vendor | Cat No. | Purity |
|---|---|---|---|---|
| Poly(propylenglycol)acrylate | 50858-51-0 | Sigma-aldrich | 469815-100ML | Contains 200-400ppm monomethyl ether hydroquinone as inhibitor |
| BHT - 2,6-Di-tert-butyl-4-methylphenol | 128-37-0 | Sigma-aldrich | B1378-100G | ≥99% |
| succinic anhydride | 108-30-5 | ACROS ORGANICS | 250 GR | 99% |
| DMAP - 4-(Dimethylamino) pyridine | 1122-58-3 | Sigma-aldrich | 107700-25G | ≥99% |
| anhydrous toluene | 108-88-3 | Sigma-aldrich | 244511-1L | 99.8% |

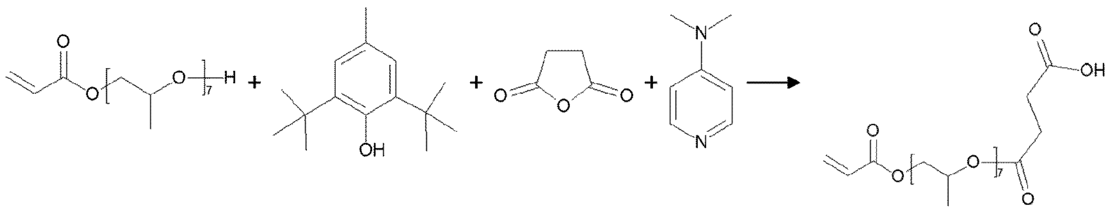

In absence of light, into 1L 3-neck round bottom flask equipped with stir bar, within soft heating mantle and thermocouple, chiller (5°C) circulation, under Ar: Poly(propylenglycol)acrylate (10.20gr), BHT (46mg), succinic anhydride (2.56gr) and DMAP (0.13gr) in anhydrous toluene (520mL) are stirred together. Reaction heated to reflux (111 °C) overnight under argon.

On the next day, the mixture is cooled down to RT, and extracted with distilled water, then with brine. Organic phase is dried over $MgSO_4$, filtered via filter paper, then volatiles is removed under reduced pressure on Rotavap.

The residue is purified using silica gel (200-425 mesh) chromatography with $CHCl_3$ followed by $CHCl_3/CH_3OH$ (97/3). Fractions are collected, volatiles removed. Each fraction is analyzed by 1H NMR and DOSY. Then compound L1 is obtained.

__Sample weight:__

Appearance: Transparent colorless liquid
Sample storage: keep under ambient atmosphere at 4°C.

-Other factors of the composition

According to the present invention, in a preferred embodiment, the viscosity of the composition is 35 cP or less at room temperature, preferably in the range from 1 to 35 cP, more preferably from 2 to 30 cP, even more preferably from 2 to 25 cP.

In a preferred embodiment of the present invention, the composition comprises a solvent 10wt% or less based on the total amount of the composition, more preferably it is 5wt% or less, more preferably it is a solvent free composition, preferably the composition does not comprise any one of the following solvent selected from one or more members of the group consisting of ethylene glycol monoalkyl ethers, such as, ethylene glycol monomethyl ether, ethylene glycol monoethyl ether, ethylene glycol monopropyl ether, and ethylene glycol monobutyl ether; diethylene glycol dialkyl ethers, such as, diethylene glycol dimethyl ether, diethylene glycol diethyl ether, diethylene glycol dipropyl ether, and diethylene glycol dibutyl ether; propylene glycol monoalkyl ethers, such as, propylene glycol monomethyl ether(PGME), propylene glycol monoethyl ether, and propylene glycol monopropyl ether; ethylene glycol alkyl ether acetates, such as, methyl cellosolve acetate and ethyl cellosolve acetate; propylene glycol alkyl ether acetates, such as, propylene glycol monomethyl ether acetate (PGMEA), propylene glycol monoethyl ether acetate, and propylene glycol monopropyl ether acetate; ketones, such as, methyl ethyl ketone, acetone, methyl amyl ketone, methyl isobutyl ketone, and cyclohexanone; alcohols, such as, ethanol, propanol, butanol, hexanol, cyclo hexanol, ethylene glycol, triethylene glycol and glycerin; esters, such as, ethyl 3-ethoxypropionate, methyl 3-methoxypropionate and ethyl lactate; and cyclic asters, such as, gamma-butyro-lactone; chlorinated hydrocarbons, such as chloroform, dichloromethane, chlorobenzene, trimethyl benzenes such as 1,3,5-trimethylbenzene, 1,2,4-trimethyl benzene, 1,2,3-trimethyl benzene, docecylbenzene, cyclohexylbenzene, 1,2,3,4-tetramethylbenzene, 1,2,3,5-tetramethylbenzene, 3-isopropylbiphenyl, 3-methylbiphenyl, 4-methylbiphenyl and dichlorobenzene, preferably said solvent is propylene glycol alkyl ether acetates, alkyl acetates, ethylene glycol monoalkyl ethers, propylene glycol, and propylene glycol monoalkyl ethers.

It is believed that the less than 10wt% of solvent in the composition leads improved ink-jetting and it can avoid $2^{nd}$ or more ink-jetting onto the same pixel after evaporation of the solvent.

According to the present invention, it is desirable not to add any solvent to realize large area inkjet printing with improved uniformity without causing any clogging at a nozzle and/or with good dispersity of semiconducting light emitting nanoparticles and/or with good dispersity of scattering particles.

According to the present invention, preferably the composition further comprises an another material selected from one or more members of the group consisting of;
another light emitting moiety which is different from the light emitting moiety of claim 1, preferably said light emitting moiety comprises a ligand, more preferably said light emitting moiety comprises an alkyl or alkenyl type ligand having carbon atoms 2 to 25, scattering particles transparent polymers, anti-oxidants, radical quenchers, photo initiators and surfactants.

In some embodiments of the present invention, preferably the composition of the present invention comprises

v) scattering particles; and

vii) at least one polymer configured so that said polymer enables to the scattering particles to be dispersed in the composition;

wherein the polymer comprises at least a phosphine group, phosphine oxide group, phosphate group, phosphonate group, thiol group, tertiary amine group, primary amine group, carboxyl group, hetero cyclic group, silane group, sulfonic acid, hydroxyl group, phosphonic acid, or a combination of thereof, preferably the polymer comprises a tertiary amine group, hydroxyl group, silane group, carboxyl group, phosphine oxide group, phosphonic acid, or a phosphate group.

According to the present invention, the polymer configured so that said polymer enables to the scattering particles to disperse in the composition comprises at least a repeating unit A comprising a phosphine group, phosphine oxide group, phosphate group, phosphonate group, thiol group, tertiary amine, carboxyl group, hetero cyclic group, silane group, sulfonic acid, hydroxyl group, phosphonic acid, or a combination of thereof.

In some embodiments of the present invention, the surface of the core, or the outermost surface of one or more shell layers of the semiconducting light emitting nanoparticle can be partly or fully over coated by the polymer.

By using ligand exchange method, described in for example, Thomas Nann, Chem. Commun., 2005, 1735 - 1736, DOI: 10.1039/b-414807j, the polymer can be introduced onto the surface of the core or the outermost surface of the core of the semiconducting light emitting nanoparticle.

According to the present invention, in some embodiments, the content of said polymer is in the range from 1% to 500% by weight, more preferably in the range from 20% to 350% by weight, even more preferably from 50% to 200% by weight with respect to the total weight of the scattering particles.

In a preferred embodiment of the present invention, the weight average molecular weight (Mw) of the polymer is in the range from 200 g/mol to 30,000 g/mol, preferably from 250 g/mol to 2,000 g/mol, more preferably from 400 g/mol to 1,000 g/mol.

The molecular weight $M_w$ is determined by means of GPC (= gel permeation chromatography) against an internal polystyrene standard.

As the polymer, commercially available wetting and dispersing additives which can be dissolved in non-polar and / or low polar organic solvent can be used preferably. Such as BYK-111, BYK-LPN6919, BYK-103, BYK-P104, BYK-163 ([trademark], from BYK com.), TERPLUS MD1000 series, such as MD1000, MD1100 ([trademark], from Otsuka Chemical), Poly(ethylene glycol) methyl ether amine (Sigma-Aldrich 767565 [trademark], from Sigma Aldrich), Polyester bis-MPA dendron, 32 hydroxyl, 1 thiol, (Sigma- Aldrich 767115 [trademark], from Sigma Aldrich), LIPONOL DA-T/25 (From Lion Specialty Chemicals Co.), Carboxymethyl cellulose (from Polyscience etc.), another wetting and dispersing additives disclosed in for examples, "Marc Thiry et. al., ACSNANO, American Chemical society, Vol. 5, No. 6, pp 4965 - 4973, 2011", "Kimihiro Susumu, et. al., J. Am. Chem. Soc. 2011, 133, pp 9480-9496".

v) Scattering particles

According to the present invention, as the scattering particles, publicly known small particles of inorganic oxides such as $SiO_2$, $SnO_2$, CuO, CoO, $Al_2O_3$, $TiO_2$, $Fe_2O_3$, $Y_2O_3$, ZnO, ZnS, MgO; organic particles such as polymerized polystyrene, polymerized PMMA; inorganic hollow oxides such as hollow silica or a combination of any of these; can be used. The amount of the scattering particles is preferably 10wt% or less based on the total amount of the contents of the layer, preferably it is in the range from 8 to 0wt%, more preferably it is in the range from 6 to 0wt%.

According to the present invention, as a transparent polymer, a wide variety of publicly known transparent polymers suitable for optical devices, described in for example, WO 2016/134820A can be used preferably.

According to the present invention, the term "transparent" means at least around 60 % of incident light transmit at the thickness used in an optical medium and at a wavelength or a range of wavelength used during operation of an optical medium. Preferably, it is over 70 %, more preferably, over 75%, the most preferably, it is over 80 %.

According to the present invention the term "polymer" means a material having a repeating unit and having the weight average molecular weight (Mw) 400 g/mol, or more, preferably in the range from 400 g/mol to 1,000,000 g/mol.

The molecular weight $M_w$ is determined by means of GPC (= gel permeation chromatography) against an internal polystyrene standard.

In some embodiments of the present invention, the glass transition temperature (Tg) of the transparent polymer is 70 °C or more and 250 °C or less.

Tg is measured based on changes in the heat capacity observed in Differential scanning colorimetry like

described in Rickey J Seyler, Assignment of the Glass Transition, ASTM publication code number (PCN) 04-012490-50.

For example, as the transparent polymer for the transparent matrix material, poly(meth)acrylates, epoxys, polyurethanes, polysiloxanes, can be used preferably.

In a preferred embodiment of the present invention, the weight average molecular weight (Mw) of the polymer as the transparent matrix material is in the range from 1,000 to 300,000 g/mol, more preferably it is from 10,000 to 250,000 g/mol.

According to the present invention, publicly known anti-oxidants, radical quenchers, photo initiators and/or surfactants can be used preferably like described in WO 2016/134820A.

-An antioxidant

According to the present invention, the composition comprises an antioxidant. In a preferred embodiment of the present invention, the total amount of said antioxidant based on the total amount of the solid content of the composition is more than 0.1wt%, preferably it is in the range from 0.1.wt% to 10wt%, more preferably it is from 0.2wt% to 5wt%, even more preferably it is from 0.3wt% to 3wt.% from the viewpoint of reducing / preventing excess of radicals in the composition during photo induced polymerization and reducing /preventing oxidation damage of the light emitting moiety.

In a preferred embodiment of the present invention, said antioxidant is selected from one or more members of the group consisting of hindered amines (e.g. tetramethyl piperidine and derivatives), phenol derivatives (e.g. MEHQ and its derivatives), quinone derivatives, thiols and unsaturated alkyles with conjugated double bonds (e.g. retinol and ints derivatives), preferably it is a phenol derivatives, more preferably it is a hindered phenol type antioxidant from the viewpoint of effectively reducing / preventing excess of radicals in the composition during photo induced polymerization, reducing /preventing oxidation damage of the light emitting moiety and/or good compatibility to the composition (especially good compatibility to the reactive monomer, the light emitting moiety and the polymerization initiator).

It is also believed that by controlling the amount of the antioxidant as indicated above, the number of radicals (here "excess radicals) can be reduced / prevented. And it enables to control a polymerization condition (e.g. polymerization speed) and it leads improved optical performance (e.g. higher EQE of the cured composition film) after curing the composition of the present invention at high UV light intensity (e.g. UV curing 10 sec at 300 mW/cm$^2$) and/or improved film layer condition (e.g. improved thermal stability of the layer, mitigation/prevention of EQE drop following thermal treatment of the layer).

-A polymerization initiator.

According to the present invention, the composition comprises a polymerization initiator. In a preferred embodiment of the present invention, the total amount of said polymerization initiator based on the total amount of the solid content of the composition is less than 10wt% and above 0wt.%, preferably it is in the range from 5wt.% to 0.01wt.%, more preferably it is from 3 to 0.1wt%, even more preferably it is from 2 to 0.1wt% from the viewpoint of controlling a polymerization, realizing improved optical performance (e.g. higher EQE of the cured composition film) after curing the composition of the present invention at high UV light intensity (e.g. UV curing 10 sec at 300 mW/cm$^2$) and/or improved film layer condition.

In a preferred embodiment of the present invention, said polymerization initiator is selected from one or more members of the group consisting of Diphenyl(2,4,6-trimethylbenzoyl)phosphine oxide, Ethyl (2,4,6-trimethylbenzoyl) phenylphosphinate, Bis(2,4,6- Trimethylbenzoyl)phenylphosphine oxide, 4,4'-Bis(dimethylamino)benzophenone, 4,4'-Bis(diethylamino)benzophenone, 4-(Dimethylamino)benzophenone, Diphenyl(2,4,6 trimethylbenzoyl)phosphine oxide, 2-Hydroxy-2-methylpropiophenone, thioxanthen-9-one, Camphorquinone, 1-Phenyl-1,2-propanedione, carbazoles such as 9-vinylcarbazole, 1,2-Octanedione 1-[4-(phenylthio) phenyl]-2(o-benzoyloxime), Ethanone 1-[9-ethyl-6-(2-methylbenzoyl)-9H-carbaaol-3-yl]-1-(O-acetyloxime),oxime esters, preferably it is selected from Bis(2,4,6-trimethylbenzoyl)-phenylphosphineoxide, Diphenyl(2,4,6-trimethylbenzoyl)phosphine oxide, Ethyl (2,4,6-trimethylbenzoyl) phenylphosphinate, a mixture of Bis(2,4,6- Trimethylbenzoyl)phenylphosphine oxide and Ethyl (2,4,6-trimethylbenzoyl) phenylphosphinate, and a combination of thereof, more preferably it is Bis(2,4,6-trimethylbenzoyl)-phenylphosphineoxide from the viewpoint of controlling a polymerization and/or realizing improved optical performance (e.g. higher EQE of the cured composition film) after curing the composition of the present invention at high UV light intensity (e.g. UV curing 10 sec at 300 mW/cm$^2$), improved film layer condition and/or good compatibility to the composition (especially good compatibility to the reactive monomer, the light emitting moiety and the antioxidant).

-The ratio of antioxidant/polymerization initiator

In a preferred embodiment of the present invention, the ratio of the total amount of the antioxidant to the total amount of the polymerization initiator is more than 0.1 and 100 or less, preferably it is in the range from 0.2 to 50, more

preferably from 0.3 to 30, even more preferably from 0.4 to 6.

It is believed that the above mentioned preferred range may lead significant technical effects: reducing / preventing excess of radicals in the composition during photo induced polymerization and reducing /preventing oxidation damage of the light emitting moiety; and controlling a polymerization and/or realizing improved optical performance (e.g. higher EQE of the cured composition film) after curing the composition of the present invention at high UV light intensity (e.g. UV curing 10 sec at 300 mW/cm$^2$), and/or improved film layer condition at the same time (e.g. improved thermal stability of the layer, mitigation/prevention of EQE drop following thermal treatment of the layer). In other words, it is believed that it may lead improved film brightness after polymerization of the composition at high UV light intensity and long term durability of the cured film.

It is believed by adjusting the ratio of antioxidant/polymerization initiator it enables to more preferably control the polymerization condition of the composition (e.g. polymerization speed) and it leads improved optical performance (e.g. higher EQE of the cured composition film) after curing the composition of the present invention at high UV light intensity (e.g. UV curing 10 sec at 300 mW/cm$^2$) and/or improved film layer condition.

-Process for fabricating the layer (100)

A process for fabricating the layer (100) of the present invention may be provided, wherein the process comprises at least the following steps;

I) providing a composition preferably from a photocurable composition, comprising at least;

i) a reactive monomer, preferably said monomer contains one or more of functional groups, more preferably said monomer is a (meth)acrylate monomer;
ii) a light emitting moiety; and optionally
iii) a chemical compound comprising at least one end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid group, preferably said group is a phosphate group, a phosphonate group, thiol group, primary amine group and a carboxyl group, more preferably it is a carboxyl group as defined in the present invention.

onto a substrate,
II) curing the composition, preferably said curing is performed by photo irradiation and/or thermal treatment, more preferably said curing is performed by photo irradiation.

A layer obtained or obtainable from the process may be provided.

-A multiple layer (300)

In another aspect, the present invention relates to a multiple layer (300) containing at least the layer of the present invention and one or more of another layers (310) where at least one of said another layers is directly attached onto the layer. Preferably said another layer is an optical layer, more preferably said another layer contains a matrix material (110), even more preferably said another layer does not contain any light emitting moiety (120).

- Color conversion device (400)

A color conversion device (400) comprising at least a pixel partly or fully filled with the layer of the present invention comprising at least a matrix material (110) containing a light emitting moiety (120), and a bank (150) comprising at least a polymer material, preferably said pixel is a 1$^{st}$ pixel (411) and/or a 2$^{nd}$ pixel (412), preferably the color conversion device (100) further contains a supporting medium (170).

- a pixel

Said pixel is partly or fully filled with the layer (100) of the present invention or the multiple layer (300) of the present invention, preferably said pixel is a 1$^{st}$ pixel (411) and/or a 2$^{nd}$ pixel (412), optionally one or more of another layers (420) placed under and/or above the layer (100) in the pixel, preferably said another layer (420) contains a matrix material (110) and it does not contain the light emitting moiety (120). In some embodiments, the pixel is a region defined/surrounded by the bank.

In some embodiments, the layer thickness of the pixel (411) is in the range from 0.1 to 100$\mu$m, preferably it is from 1 to 50$\mu$m, more preferably from 5 to 25$\mu$m.

In some embodiments, the color conversion device (400) contains a 1$^{st}$ pixel (412) and a 2$^{nd}$ pixel (412), preferably the device (400) contains at least said 1$^{st}$ pixel (411), 2$^{nd}$ pixel (412) and a 3$^{rd}$ pixel (413), more preferably said 1$^{st}$ pixel (411) is a red color pixel, the 2$^{nd}$ pixel (412) is a green color pixel and the 3$^{rd}$ pixel (413) is a blue color pixel, even more preferably the 1$^{st}$ pixel (411) contains a red light emitting moiety (120R), the 2$^{nd}$ color pixel (412) contains a green light emitting moiety (120G) and the 3$^{rd}$ pixel (413) does not contain any light emitting moiety.

In some embodiments, at least one pixel (411, 412 and/or 413) additionally comprises at least one light scattering particle (130) in the matrix material (110), preferably the pixel (411, 412 and/or 413) contains a plurality of light scattering particles (130), more preferably all the pixels (411), (412) and (413) contains a plurality of light scattering particles.

In some embodiments, said 1$^{st}$ pixel (411) consists of one pixel or two or more sub-pixels configured to emit red-color when irradiated by an excitation light, more preferably said sub-pixels contains the same light emitting moiety (120).

- Matrix material (110)

In a preferable embodiment, the matrix material (110) contains a (meth)acrylate polymer, preferably it is a methacrylate polymer, an acrylate polymer or a combination of thereof, more preferably it is an acrylate polymer, even more preferably said matrix material (110) is obtained or obtainable from the composition of the present invention containing at least one acrylate monomer, further more preferably said matrix material (110) is obtained or obtainable from the composition of the present invention containing at least one di-acrylate monomer, particularly preferably said matrix material (110) is obtained or obtainable from the composition of the present invention containing at least one di-acrylate monomer and a mono-acrylate monomer, preferably said composition is a photosensitive composition.

- Bank (430)

In some embodiments, the height of the bank (430) is in the range from 0.1 to 100$\mu$m, preferably it is from 1 to 50$\mu$m, more preferably from 1 to 25$\mu$m, furthermore preferably from 5 to 20$\mu$m.

In a preferred embodiment, the bank (430) is configured to determine the area of said pixel and at least a part of the bank (430) is directly contacting to at least a part of the pixel, preferably said 2$^{nd}$ polymer of the bank (430) is directly contacting to at least a part of the 1$^{st}$ polymer of the pixel, preferably said pixel is a 1$^{st}$ pixel (411) and/or a 2$^{nd}$ pixel (412).

More preferably, said bank (430) is photolithographically patterned and said 1$^{st}$ pixel (411) is surrounded by the bank (430), preferably said 1$^{st}$ pixel (411), the 2$^{nd}$ pixel (412) and the 3$^{rd}$ pixel (413) are all surrounded by the photolithographically patterned bank (430).

A color conversion device (400) obtainable or obtained from the disclosed process may be provided.

According to the present invention, the term "bank" means a black matrix used for an optical device defining the pixel regions like described in JP 2021-075660 A, WO 2017-138607 A1, JP 2018-203599 A.

According to the present invention, said bank can be made with using a publicly known technology like described in WO 2021/018927 A1.

A use of the color conversion device (100) of the present invention in an optical device (500) containing at least one functional medium (510) configured to modulate a light or configured to emit light may be provided.

Further, in another aspect, the present invention further relates to an optical device (500) containing at least one functional medium (510) configured to modulate a light or configured to emit light, and the color conversion device (400) of the present invention.

In some embodiments of the present invention, the optical device can be a liquid crystal display device (LCD), Organic Light Emitting Diode display device (OLED), backlight unit for an optical display, Light Emitting Diode device (LED), Micro Electro Mechanical Systems (here in after "MEMS"), electro wetting display, or an electrophoretic display, a lighting device, and / or a solar cell.

Preferably, the optical device is a LCD or OLED, more preferably it is OLED.

## Technical effects of the invention

The present invention provides one or more of the following technical effects:
realizing improved layer brightness of a cured composition film, realizing improved optical performance (e.g. higher EQE value of the cured composition film) after curing the composition either at low UV intensity (e.g. UV curing at 2.3mW/cm$^2$) or at high UV light intensity (e.g. UV curing 10 sec at 300 mW/cm$^2$), preferably realizing improved optical performance (e.g. higher EQE of the cured composition film) after curing the composition at high UV light intensity (e.g. UV curing 10 sec at 300 mW/cm$^2$) and/or improved film layer condition such as improved thermal stability of the layer, mitigation/prevention of EQE drop following thermal treatment of the layer, preferably realizing these at the same time; realizing improved film

brightness after polymerization of the composition at high UV light intensity and long term durability of the cured film; realizing blue shift of the peak maximum wavelength (PWL) of light from a cured composition film layer, improved PWL value of the film layer, reducing/preventing red shift of the peak maximum wavelength of light emitted from a cured composition film layer.

The working examples below provide descriptions of the present invention, as well as an in-detail description of their fabrication. However, the present invention is not necessary to be limited to the working examples.

**Working** Examples

LA: lauryl acrylate

HDDA: 1,6-hexanediol diacrylate

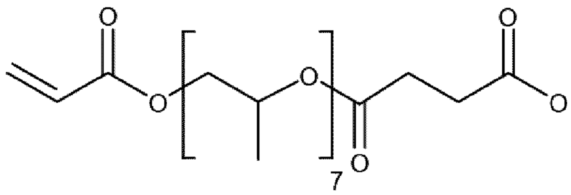

Compound L1

AO: Antioxidant
PI: Polymerization initiator
wt%: total amount in composition

<u>**Working example** 1:</u>

22.5 mg of oleic acid and 450 mg of InP based green QDs having ZnSe/ZnS double shell layers dispersed in 3 g octane are heated at 40 deg. C for 2 hours under inert atmospere. Then 385 mg of LA, 96 mg of HDDA, 10 mg of Phenylbis(2,4,6-trimethylbenzoyl)phosphine oxide (Omnirad(™)819) as PI and 5 mg of Irganox(™)1010 as AO are added. The mixture is left stirring for 10 min. Volatuiles removed under reduced pressure, 30 mg TiO2 is added. Then the QD ink composition 1 is obtained. Film A and Film B with 10 um thickness are fabricated using the QD ink composition 1. Film A and B are prepared by bar coating of the ink on silicone wafer. Then Film A is cured under argon at 2.3 mW/cm$^2$ for 10 min and Film B is cured under argon at 300mW/cm$^2$ for 10 sec. FIB lamella cuts of the obtained Film A and Film B are analyzed by SEM.

Figures 6a, 6b. Films A and B fabricated from QD ink composition 1 described in Working example 1

a) Film A cured at 2.3 mW/cm$^2$ for 10 min. SEM image.
b) Film B cured at 300 mW/cm$^2$ for 10 sec. SEM image.

<u>**Working example 2:**</u>

22 mg of linoleic acid, 500 mg of InP based green QDs having ZnSe/ZnS double shell layers dispersed in 3.4 g octane and 1.7 g toluene are stirred at ambient temperature for 2 hours under inert atmospere. Then 323 mg of LA, 81 mg of HDDA, 5 mg of Phenylbis(2,4,6-trimethylbenzoyl)phosphine oxide (Omnirad(™)819) as PI and 20 mg of Irganox(™)1010 as AO are added. The mixture is left stirring for 10 min. Volatuiles removed under reduced pressure, 50 mg TiO2 is added. Then the QD ink composition 2 is obtained.

Film C and Film D with 10 um thickness are fabricated using the QD ink composition 2. Film C and D are prepared by bar coating of the ink on silicone wafer. Then Film C is cured under argon at 2.3 mW/cm$^2$ for 10 min and Film D is cured under argon at 300mW/cm$^2$ for 10 sec. FIB lamella cuts of the obtained Film C and Film D are analyzed by SEM.

Figures 7a, 7b. Films C and D fabricated from QD ink composition 2 described in Working example 2.

a) Film C cured at 2.3 mW/cm$^2$ for 10 min. SEM image.
b) Film D cured at 300 mW/cm$^2$ for 10 sec. SEM image.

**Working example 3:**

102 mg of Compound L1, 948 mg of InP based green QDs having ZnSe/ZnS double shell layers dispersed in 7 g octane and 3.6 g THF are stirred at 40 deg. C for 2 hours under inert atmospere. Then 620 mg of LA, 163 mg of HDDA, 20 mg of Phenylbis(2,4,6-trimethylbenzoyl)phosphine oxide (Omnirad(™)819) as PI and 10 mg of Irganox(™)1010 as AO are added. The mixture is left stirring for 10 min. Volatuiles removed under reduced pressure, 100 mg TiO2 is added.
Film E and Film F with 10 um thickness are fabricated using the QD ink composition 2. Film E and F are prepared by bar coating of the ink on silicone wafer. Then Film E is cured under argon at 2.3 mW/cm$^2$ for 10 min and Film F is cured under argon at 300mW/cm$^2$ for 10 sec. FIB lamella cuts of the obtained Film E and Film F are analyzed by SEM.
Figures 8a, 8b. Films E and F fabricated from QD ink composition 3 described in Working example 3.

a) Film E cured at 2.3 mW/cm$^2$ for 10 min. SEM image.
b) Film F cured at 300 mW/cm$^2$ for 10 sec. SEM image.

**Working Example 4:** EQE measurement

To perform evaluation of performance of QD inks described in Working Examples 1 to 3, 10um films are fabricated by filling glass sandwich test cell with a QD ink composiiton. To make films A, C and E, QD ink compositon inside the glass cell is cured under argon at 2.3 mW/cm$^2$ for 10 min. To make films B, D and F, QD ink compositon inside the glass cell is cured under argon at 300 mW/cm$^2$ for 10 sec. EQE measurement of the films A to F is carried out by using integrating sphere equipped with excitation light by optical fiber (CWL: 450nm) and spectrometer (Compass X, BWTEK). To detect the photons of the excitation light, air is used as a reference at room temperature.
The number of photons of light emission from the test cell towards the integrating sphere is counted by the spectrometer at room temperature.
EQE is calculated by the following calculation Method.

EQE = Photons [**Emission light**]/ Photons [**Excitation light** measured without sample in place]

Wavelength Range for Calculation

Excitation: 390nm-490nm
Emission: [Green] 490-600nm

Following table 1 show the results of the measurements.

Table 1:

| Ink | EQE, %<br>Film cured at 2.3 mW/cm$^2$ for 10 min | EQE, %<br>Film cured at 300 mW/cm$^2$ for 10 sec |
|---|---|---|
| Working example 1 | 32.5 (Film A) | 31.2 (Film B) |
| Working example 2 | 33.9 (Film C) | 34.1(Film D) |
| Working example 3 | 34.2 (Film E) | 33.7 (Film F) |

**Working Example 5:** Evaluation of distribution of QDs in the film:

To estimate % of QDs in % of film thickness, integrated area under selenium profile limited by % of film thickness is devided by integrated area under selenium profile over full film thickness by EDS linescan.
Starting point of the EDS linescan is at silicone wafer (below the lower surface of the film) and the end point of the EDS line scan is over the top surface of the film.
Selenium is chosen because of composition of the light emitting moiety (QDs) disclosed in the working examples. The disclosed effect of film morphology on film brightness shall not be limited by composition of light emitting moiety disclosed in the working examples.
Figure 9A: shows the Se profile of Film A cured at 2.3 mW/cm$^2$ for 10 min.
Figure 9B shows the Se profile of Film B cured at 300 mW/cm$^2$ for 10 sec.

Table 2: Distribution of QDs in films made of ink described in Working example 1. Zero thickness is defined at silicone wafer.

| | % QD fraction | |
|---|---|---|
| % film thickness | Film A cured at 2.3 $mW/cm^2$ for 10 min | Film B cured at 300 $mW/cm^2$ for 10 sec |
| 23.8 | 47.6 | 33.6 |
| 38.4 | 63.7 | 51.1 |
| 80.7 | 84.0 | 87.9 |

## Claims

**1.** A layer (100) comprising at least a matrix material (110) and one or more light emitting moieties (120), wherein the distribution of the light emitting moiety (120) in the layer is not identical in the direction of layer thickness;

wherein said layer is made from a composition, preferably made from a photocurable composition, comprising at least;

i) a reactive monomer; and
ii) a light emitting moiety;

and said reactive monomer of the composition is a (meth)acrylate monomer selected from a mono-(meth)acrylate monomer, a di-(meth)acrylate monomer or a tri-(meth)acrylate monomer; and
wherein the composition further comprises a (meth)acrylate monomer represented by following chemical formula (I) and/or a (meth)acrylate monomer represented by following chemical formula (III);

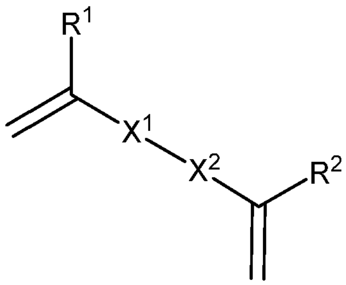

(I)

wherein
$X^1$ is a non-substituted or substituted alkyl group, aryl group or an alkoxy group or an ester group;
$X^2$ is a non-substituted or substituted alkyl group, aryl group or an alkoxy group or an ester group;
R' is a hydrogen atom, halogen atom of Cl, Br, or F, methyl group, alkyl group, aryl group, alkoxy group, ester group, or a carboxylic acid group;
$R^2$ is a hydrogen atom, halogen atom of Cl, Br, or F, methyl group, alkyl group, aryl group, alkoxy group, ester group, or a carboxylic acid group;

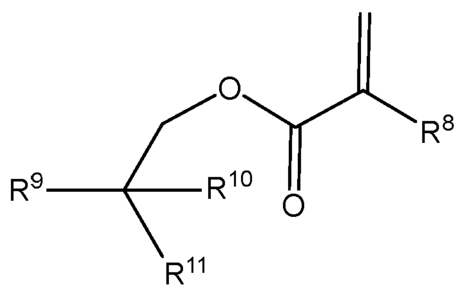

(III);

wherein $R^9$ is hydrogen atom, a straight alkyl group having 1 to 25 carbon atoms or a (meth)acryl group

represented by chemical formula (IV)

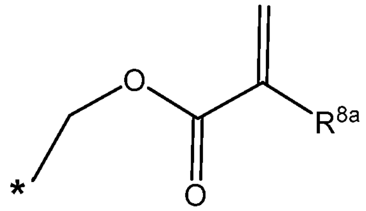

(IV);

$R^{10}$ is hydrogen atom, a straight alkyl group having 1 to 25 carbon atoms or a (meth)acryl group represented by chemical formula (V)

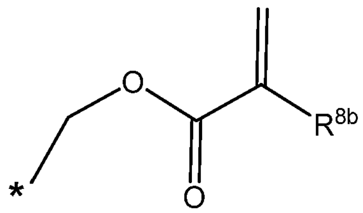

(V);

$R^{11}$ is hydrogen atom, a straight alkyl group having 1 to 25 carbon atoms or a (meth)acryl group represented by chemical formula (VI)

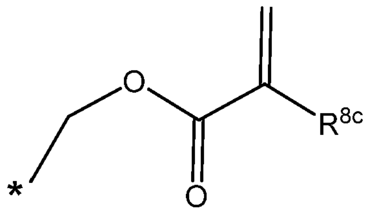

(VI);

wherein $R^8$, $R^{8a}$, $R^{8b}$ and $R^{8c}$ are, each independently or dependently of each other at each occurrence, H, $CH_2CH_3$ or $CH_3$;
wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms.

**2.** A layer (100) containing at least a matrix material (110) and one or more light emitting moieties (120), contains a 1st phase (210) and a 2nd phase (220), wherein said 1st phase (210) and said 2nd phase (220) are different of each other and said 1st phase (210) has a plurality of aggregates (211) of said light emitting moieties (120) and higher concentration of the light emitting moieties per unit volume in the 1st phase (210) than in the 2nd phase (220);

wherein said layer is made from a composition, preferably made from a photocurable composition, comprising at least;

i) a reactive monomer; and
ii) a light emitting moiety;

and said reactive monomer of the composition is a (meth)acrylate monomer selected from a mono-(meth)acrylate monomer, a di-(meth)acrylate monomer or a tri-(meth)acrylate monomer; and
wherein the composition further comprises a (meth)acrylate monomer represented by following chemical formula (I) and/or a (meth)acrylate monomer represented by following chemical formula (III);

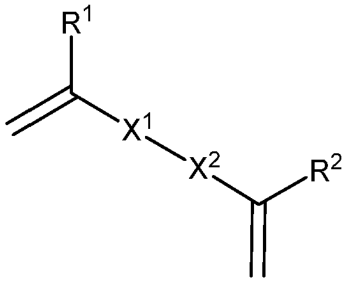

(I)

wherein
$X^1$ is a non-substituted or substituted alkyl group, aryl group or an alkoxy group or an ester group;
$X^2$ is a non-substituted or substituted alkyl group, aryl group or an alkoxy group or an ester group;
$R^1$ is a hydrogen atom, halogen atom of Cl, Br, or F, methyl group, alkyl group, aryl group, alkoxy group, ester group, or a carboxylic acid group;
$R^2$ is a hydrogen atom, halogen atom of Cl, Br, or F, methyl group, alkyl group, aryl group, alkoxy group, ester group, or a carboxylic acid group;

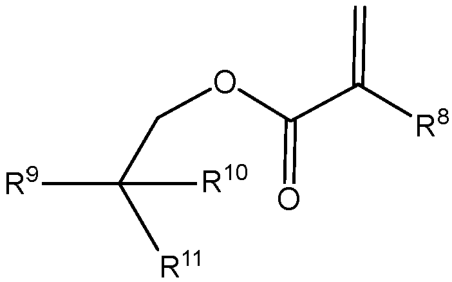

(III);

wherein $R^9$ is hydrogen atom, a straight alkyl group having 1 to 25 carbon atoms or a (meth)acryl group represented by chemical formula (IV)

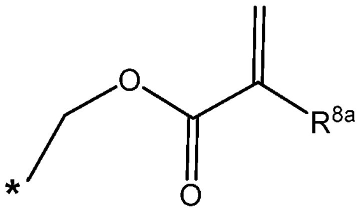

(IV);

$R^{10}$ is hydrogen atom, a straight alkyl group having 1 to 25 carbon atoms or a (meth)acryl group represented by chemical formula (V)

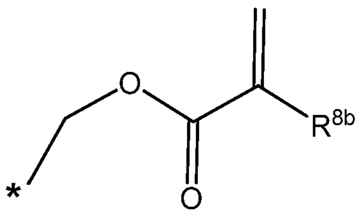

(V);

$R^{11}$ is hydrogen atom, a straight alkyl group having 1 to 25 carbon atoms or a (meth)acryl group represented by chemical formula (VI)

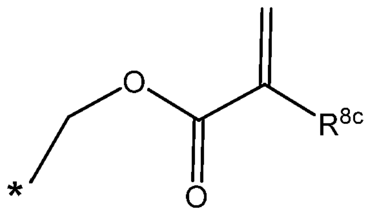

(VI);

wherein $R^8$, $R^{8a}$, $R^{8b}$ and $R^{8c}$ are, each independently or dependently of each other at each occurrence, H, $CH_2CH_3$ or $CH_3$;
wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms.

**3.** A layer (100) containing at least a matrix material (110) and one or more light emitting moieties (120), wherein 30 wt % or more of the light emitting moieties (120) based on the total amount of the light emitting moieties in the layer are concentrated in an area (160) of the layer, wherein said area (160) has the thickness within 25% of the thickness of the layer;

wherein said layer is made from a composition, preferably made from a photocurable composition, comprising at least;

i) a reactive monomer; and
ii) a light emitting moiety;

and said reactive monomer of the composition is a (meth)acrylate monomer selected from a mono-(meth)acrylate monomer, a di-(meth)acrylate monomer or a tri-(meth)acrylate monomer; and
wherein the composition further comprises a (meth)acrylate monomer represented by following chemical formula (I) and/or a (meth)acrylate monomer represented by following chemical formula (III);

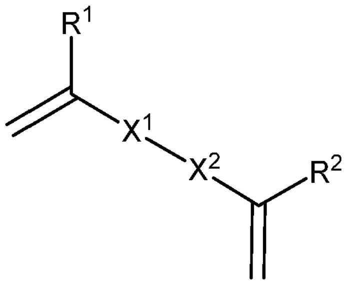

(I)

wherein
$X^1$ is a non-substituted or substituted alkyl group, aryl group or an alkoxy group or an ester group;
$X^2$ is a non-substituted or substituted alkyl group, aryl group or an alkoxy group or an ester group;
$R^1$ is a hydrogen atom, halogen atom of Cl, Br, or F, methyl group, alkyl group, aryl group, alkoxy group, ester group, or a carboxylic acid group;
$R^2$ is a hydrogen atom, halogen atom of Cl, Br, or F, methyl group, alkyl group, aryl group, alkoxy group, ester group, or a carboxylic acid group;

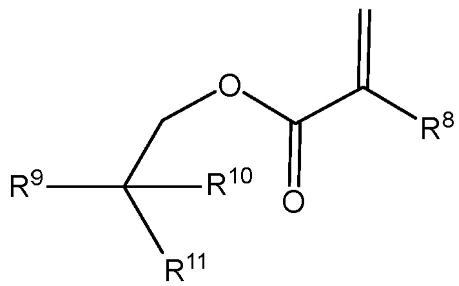

(III);

wherein $R^9$ is hydrogen atom, a straight alkyl group having 1 to 25 carbon atoms or a (meth)acryl group represented by chemical formula (IV)

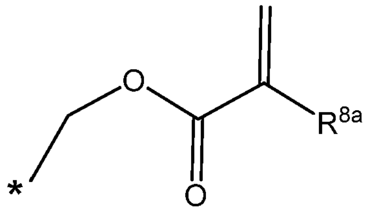

(IV);

$R^{10}$ is hydrogen atom, a straight alkyl group having 1 to 25 carbon atoms or a (meth)acryl group represented by chemical formula (V)

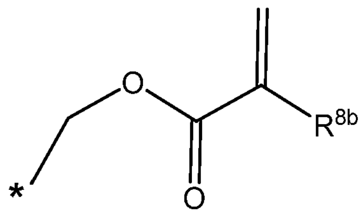

(V);

$R^{11}$ is hydrogen atom, a straight alkyl group having 1 to 25 carbon atoms or a (meth)acryl group represented by chemical formula (VI)

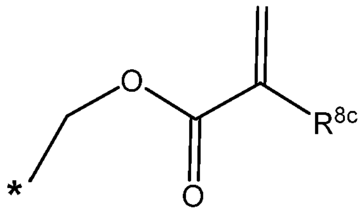

(VI);

wherein $R^8$, $R^{8a}$, $R^{8b}$ and $R^{8c}$ are, each independently or dependently of each other at each occurrence, H, $CH_2CH_3$ or $CH_3$;
wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms.

**4.** A layer (100) containing at least a matrix material (110) and one or more light emitting moieties (120), wherein 41 wt.% or more of the light emitting moieties (120) based on the total amount of the light emitting moieties in the layer are concentrated in the area (160) of the layer, wherein said area (160) has the thickness within 40% of the layer thickness of the layer; wherein said layer is made from a composition, preferably made from a photocurable composition, comprising at least;

i) a reactive monomer; and
ii) a light emitting moiety;
and said reactive monomer of the composition is a (meth)acrylate monomer selected from a mono-(meth)acrylate monomer, a di-(meth)acrylate monomer or a tri-(meth)acrylate monomer; and
wherein the composition further comprises a (meth)acrylate monomer represented by following chemical formula (I) and/or a (meth)acrylate monomer represented by following chemical formula (III);

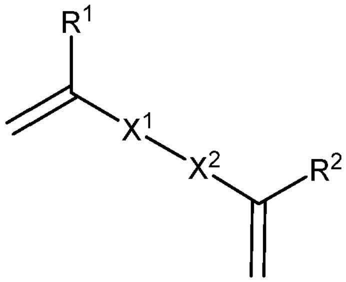

(I)

wherein

$X^1$ is a non-substituted or substituted alkyl group, aryl group or an alkoxy group or an ester group;

$X^2$ is a non-substituted or substituted alkyl group, aryl group or an alkoxy group or an ester group;

$R^1$ is a hydrogen atom, halogen atom of Cl, Br, or F, methyl group, alkyl group, aryl group, alkoxy group, ester group, or a carboxylic acid group;

$R^2$ is a hydrogen atom, halogen atom of Cl, Br, or F, methyl group, alkyl group, aryl group, alkoxy group, ester group, or a carboxylic acid group;

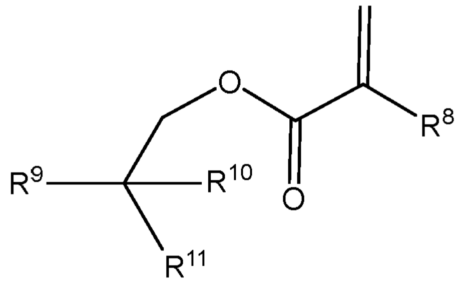

(III);

wherein $R^9$ is hydrogen atom, a straight alkyl group having 1 to 25 carbon atoms or a (meth)acryl group represented by chemical formula (IV)

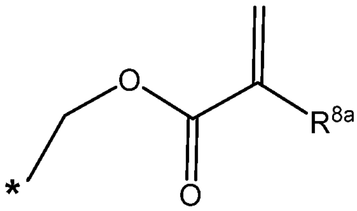

(IV);

$R^{10}$ is hydrogen atom, a straight alkyl group having 1 to 25 carbon atoms or a (meth)acryl group represented by chemical formula (V)

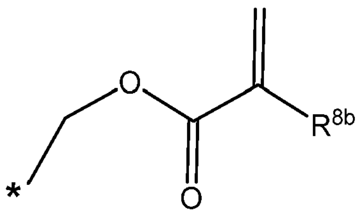

(V);

$R^{11}$ is hydrogen atom, a straight alkyl group having 1 to 25 carbon atoms or a (meth)acryl group represented by chemical formula (VI)

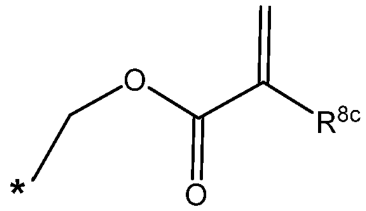

(VI);

wherein $R^8$, $R^{8a}$, $R^{8b}$ and $R^{8c}$ are, each independently or dependently of each other at each occurrence, H, $CH_2CH_3$ or $CH_3$;
wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms.

**5.** The layer (100) of any one of claims 1 to 4, wherein the layer thickness of the layer (100) is in the range from 1 to 50 um.

**6.** The layer (100) of any one of claims 1 to 5, shows the EQE value 25% or more and less than 50%.

**7.** The layer (100) of any one of claims 1 to 6, is made from the composition, preferably from a photocurable composition, further comprises
iii) a chemical compound comprising at least one end group selected from one or more of members of the group consisting of phosphine group, phosphine oxide group, phosphate group, phosphonate group, thiol group, tertiary amine group, primary amine group, carboxyl group, hetero cyclic group, silane group, sulfonic acid group, hydroxyl group, phosphonic acid group.

**8.** The layer (100) of claim 7, wherein the reactive monomer of the composition is represented by following chemical formula (II);

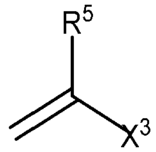

(II)

$X^3$ is a non-substituted or substituted alkyl group, aryl group or an alkoxy group;
preferably the symbol $X^3$ is

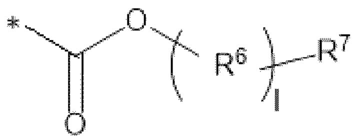

,

where "*" on the left side of the formula represents the connecting point to the end group $C=CR^5$ of the formula (I);
l is 0 or 1;
$R^5$ is a hydrogen atom, halogen atom of Cl, Br, or F, methyl group, alkyl group, aryl group, alkoxy group, ester group, or a carboxylic acid group;
$R^6$ is a straight alkylene chain or alkoxylene chain having 1 to 25 carbon atoms, preferably $R^6$ is a straight alkylene chain or alkoxylene chain having1 to 15 carbon atoms, more preferably 1 to 5 carbon atoms,
which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;
$R^7$ is a straight alkyl chain or alkoxyl chain having 1 to 25 carbon atoms, preferably $R^7$ is a straight alkyl chain or alkoxyl chain having1 to 15 carbon atoms, more preferably 1 to 5 carbon atoms,
which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another.

**9.** The layer (100) of claim 7 or 8, wherein the (meth)acrylate monomer of chemical formula (II) is in the composition and the mixing ratio of the (meth)acrylate monomer of chemical formula (I) to the (meth)acrylate monomer of chemical formula (II) is in the range from 1:99 to 99:1 (formula (I) : formula (II)), preferably from 5:95 to 50:50, more preferably from 10:90 to 40:60, even more preferably it is from 15:85 to 35:65, preferably at least a purified (meth)acrylate monomer represented by chemical formula (1), (II) is used in the composition, more preferably the (meth)acrylate monomer of chemical formula (I) and the (meth)acrylate monomer of chemical formula (II) are both obtained or obtainable by a purification method.

**10.** The layer (100) of any one of claims 1 to 9, comprises an another material selected from one or more members of the group consisting of;
another light emitting moiety which is different from the light emitting moiety of claim 1, scattering particles, transparent polymers, anti-oxidants, radical quenchers, photo initiators and surfactants.

**11.** A multiple layer (300) containing at least the layer of any one of claims 1 to 10 and one another layer (310) directly attached onto the layer.

**12.** A color conversion device (400) comprising at least xi) a pixel partly or fully filled with the layer (100) of any one of claims 1 to 10 or the multiple layer (300) of claim 11, optionally one or more of another layers (420) placed under and/or above the layer (100) in the pixel; and
xii) a bank (430) comprising at least a polymer material.

**13.** An optical device (500) containing at least one functional medium (510) configured to modulate a light or configured to emit light, and the color conversion device (400) of claim 12.

**Patentansprüche**

**1.** Schicht (100), umfassend mindestens ein Matrixmaterial (110) und eine oder mehrere lichtemittierende Komponenten (120), wobei die Verteilung der lichtemittierenden Komponente (120) in der Schicht in Richtung der Schichtdicke nicht identisch ist;

wobei die Schicht aus einer Zusammensetzung hergestellt ist, die bevorzugt aus einer photohärtbaren Zusammensetzung hergestellt ist, die mindestens Folgendes umfasst;

i) ein reaktives Monomer; und
ii) eine lichtemittierende Komponente;

und wobei das reaktive Monomer der Zusammensetzung ein (Meth)acrylatmonomer ist, das aus einem Mono(meth)acrylatmonomer, einem Di(meth)acrylatmonomer oder einem Tri(meth)acrylatmonomer ausgewählt ist; und
wobei die Zusammensetzung ferner ein (Meth)acrylatmonomer, das durch die folgende chemische Formel (I) dargestellt ist, und/oder ein (Meth)acrylatmonomer, das durch die folgende chemische Formel (III) dargestellt ist, umfasst;

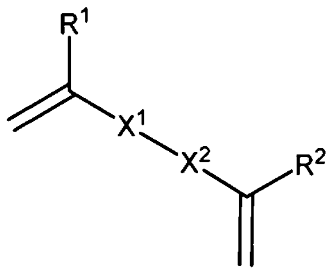

(I)

wobei
$X^1$ eine nicht substituierte oder substituierte Alkylgruppe, Arylgruppe oder eine Alkoxygruppe oder eine Estergruppe ist;
$X^2$ eine nicht substituierte oder substituierte Alkylgruppe, Arylgruppe oder eine Alkoxygruppe oder eine Estergruppe ist;
$R^1$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;
$R^2$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

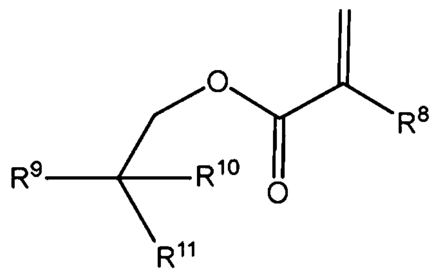

(III);

wobei $R^9$ ein Wasserstoffatom, eine gerade Alkylgruppe mit 1 bis 25 Kohlenstoffatomen oder eine (Meth) acrylgruppe, die durch die chemische Formel (IV) dargestellt ist, ist

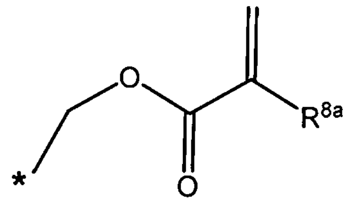

(IV);

$R^{10}$ ein Wasserstoffatom, eine gerade Alkylgruppe mit 1 bis 25 Kohlenstoffatomen oder eine (Meth)acrylgruppe, die durch die chemische Formel (V) dargestellt ist, ist

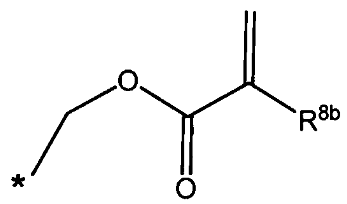

(V);

$R^{11}$ ein Wasserstoffatom, eine gerade Alkylgruppe mit 1 bis 25 Kohlenstoffatomen oder eine (Meth)acrylgruppe, die durch die chemische Formel (VI) dargestellt ist, ist

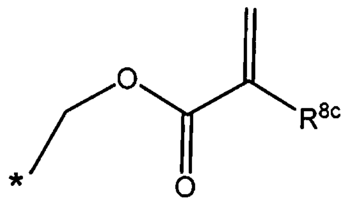

(VI);

wobei $R^8$, $R^{8a}$, $R^{8b}$ und $R^{8c}$ jeweils unabhängig oder abhängig voneinander bei jedem Auftreten H, $CH_2CH_3$ oder $CH_3$ sind;
wobei mindestens eines von $R^9$, $R^{10}$ und $R^{11}$ eine (Meth)acrylgruppe ist, bevorzugt zwei von $R^9$, $R^{10}$ und $R^{11}$ eine (Meth)acrylgruppe sind und ein anderes ein Wasserstoffatom oder eine gerade Alkylgruppe mit 1 bis 25 Kohlenstoffatomen ist.

**2.** Schicht (100), enthaltend mindestens ein Matrixmaterial (110) und eine oder mehrere lichtemittierende Komponenten (120), enthält eine 1. Phase (210) und eine 2. Phase (220), wobei sich die 1. Phase (210) und die 2. Phase (220) voneinander unterscheiden und die 1. Phase (210) eine Vielzahl von Aggregaten (211) der lichtemittierenden Komponenten (120) aufweist und eine höhere Konzentration der lichtemittierenden Komponenten pro Volumeneinheit in der 1. Phase (210) als in der 2. Phase (220) vorhanden ist;

wobei die Schicht aus einer Zusammensetzung hergestellt ist, die bevorzugt aus einer photohärtbaren Zusammensetzung hergestellt ist, die mindestens Folgendes umfasst;

i) ein reaktives Monomer; und
ii) eine lichtemittierende Komponente;

und das reaktive Monomer der Zusammensetzung ein (Meth)acrylatmonomer ist, das aus einem Mono(meth)acrylatmonomer, einem Di(meth)acrylatmonomer oder einem Tri(meth)acrylatmonomer ausgewählt ist; und wobei die Zusammensetzung ferner ein (Meth)acrylatmonomer, das durch die folgende chemische Formel (I) dargestellt ist, und/oder ein (Meth)acrylatmonomer, das durch die folgende chemische Formel (III) dargestellt ist, umfasst;

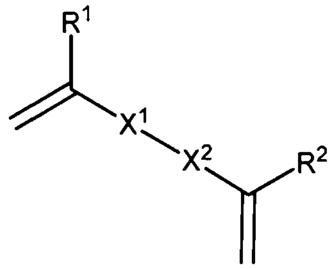

(I)

wobei
$X^1$ eine nicht substituierte oder substituierte Alkylgruppe, Arylgruppe oder eine Alkoxygruppe oder eine Estergruppe ist;
$X^2$ eine nicht substituierte oder substituierte Alkylgruppe, Arylgruppe oder eine Alkoxygruppe oder eine Estergruppe ist;
$R^1$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;
$R^2$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

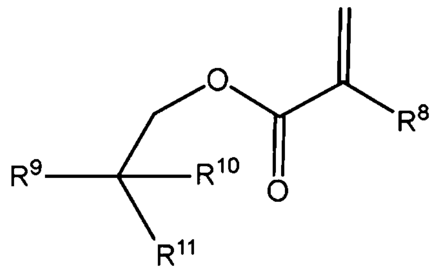

(III);

wobei $R^9$ ein Wasserstoffatom, eine gerade Alkylgruppe mit 1 bis 25 Kohlenstoffatomen oder eine (Meth) acrylgruppe, die durch die chemische Formel (IV) dargestellt ist, ist

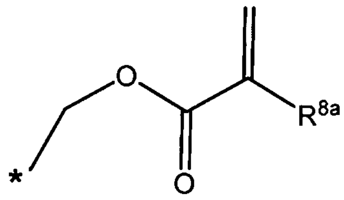

(IV);

$R^{10}$ ein Wasserstoffatom, eine gerade Alkylgruppe mit 1 bis 25 Kohlenstoffatomen oder eine (Meth)acrylgruppe, die durch die chemische Formel (V) dargestellt ist, ist

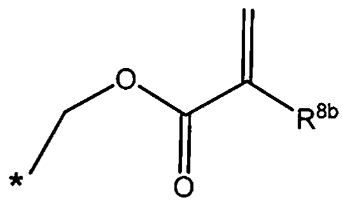

(V);

$R^{11}$ ein Wasserstoffatom, eine gerade Alkylgruppe mit 1 bis 25 Kohlenstoffatomen oder eine (Meth)acrylgruppe, die durch die chemische Formel (VI) dargestellt ist, ist

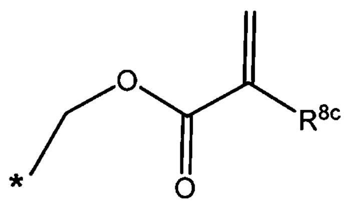

(VI);

wobei $R^8$, $R^{8a}$, $R^{8b}$ und $R^{8c}$ jeweils unabhängig oder abhängig voneinander bei jedem Auftreten H, $CH_2CH_3$ oder $CH_3$ sind;
wobei mindestens eines von $R^9$, $R^{10}$ und $R^{11}$ eine (Meth)acrylgruppe ist, bevorzugt zwei von $R^9$, $R^{10}$ und $R^{11}$ eine (Meth)acrylgruppe sind und ein anderes ein Wasserstoffatom oder eine gerade Alkylgruppe mit 1 bis 25 Kohlenstoffatomen ist.

3. Schicht (100), enthaltend mindestens ein Matrixmaterial (110) und eine oder mehrere lichtemittierende Komponenten (120), wobei 30 Gew.-% oder mehr der lichtemittierenden Komponenten (120), basierend auf der Gesamtmenge der lichtemittierenden Komponenten in der Schicht, in einem Bereich (160) der Schicht konzentriert sind, wobei der Bereich (160) die Dicke innerhalb von 25 % der Dicke der Schicht aufweist;

wobei die Schicht aus einer Zusammensetzung hergestellt ist, die bevorzugt aus einer photohärtbaren Zusammensetzung hergestellt ist, die mindestens Folgendes umfasst;

i) ein reaktives Monomer; und
ii) eine lichtemittierende Komponente;

und das reaktive Monomer der Zusammensetzung ein (Meth)acrylatmonomer ist, das aus einem Mono(meth)acrylatmonomer, einem Di(meth)acrylatmonomer oder einem Tri(meth)acrylatmonomer ausgewählt ist; und wobei die Zusammensetzung ferner ein (Meth)acrylatmonomer, das durch die folgende chemische Formel (I) dargestellt ist, und/oder ein (Meth)acrylatmonomer, das durch die folgende chemische Formel (III) dargestellt ist, umfasst;

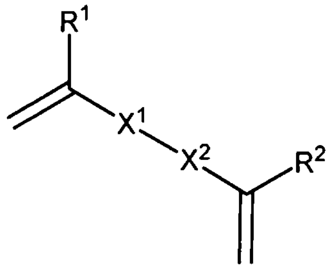

(I)

wobei
$X^1$ eine nicht substituierte oder substituierte Alkylgruppe, Arylgruppe oder eine Alkoxygruppe oder eine Estergruppe ist;
$X^2$ eine nicht substituierte oder substituierte Alkylgruppe, Arylgruppe oder eine Alkoxygruppe oder eine Estergruppe ist;
$R^1$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;
$R^2$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

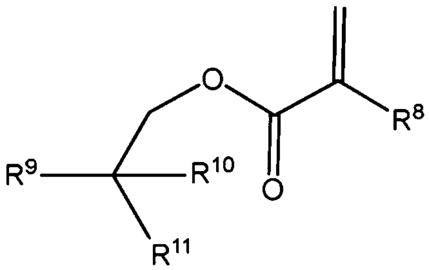

(III);

wobei $R^9$ ein Wasserstoffatom, eine gerade Alkylgruppe mit 1 bis 25 Kohlenstoffatomen oder eine (Meth)acrylgruppe, die durch die chemische Formel (IV) dargestellt ist, ist

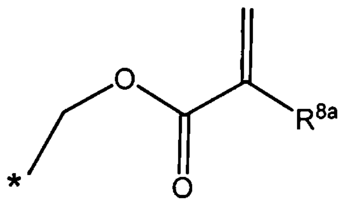

(IV);

$R^{10}$ ein Wasserstoffatom, eine gerade Alkylgruppe mit 1 bis 25 Kohlenstoffatomen oder eine (Meth)acrylgruppe, die durch die chemische Formel (V) dargestellt ist, ist

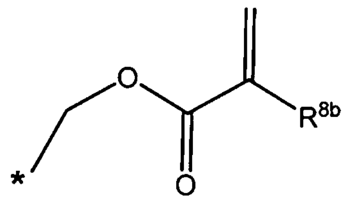

(V);

$R^{11}$ ein Wasserstoffatom, eine gerade Alkylgruppe mit 1 bis 25 Kohlenstoffatomen oder eine (Meth)acrylgruppe, die durch die chemische Formel (VI) dargestellt ist, ist

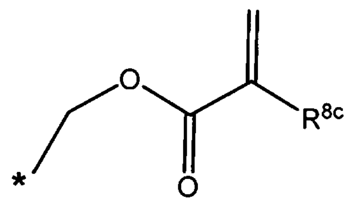

(VI);

wobei $R^8$, $R^{8a}$, $R^{8b}$ und $R^{8c}$ jeweils unabhängig oder abhängig voneinander bei jedem Auftreten H, $CH_2CH_3$ oder $CH_3$ sind;
wobei mindestens eines von $R^9$, $R^{10}$ und $R^{11}$ eine (Meth)acrylgruppe ist, bevorzugt zwei von $R^9$, $R^{10}$ und $R^{11}$ eine (Meth)acrylgruppe sind und ein anderes ein Wasserstoffatom oder eine gerade Alkylgruppe mit 1 bis 25 Kohlenstoffatomen ist.

**4.** Schicht (100), enthaltend mindestens ein Matrixmaterial (110) und eine oder mehrere lichtemittierende Komponenten (120), wobei 41 Gew.-% oder mehr der lichtemittierenden Komponenten (120), basierend auf der Gesamtmenge der lichtemittierenden Komponenten in der Schicht, in dem Bereich (160) der Schicht konzentriert sind, wobei der Bereich (160) die Dicke innerhalb von 40 % der Schichtdicke der Schicht aufweist; wobei die Schicht aus einer Zusammensetzung hergestellt ist, die bevorzugt aus einer photohärtbaren Zusammensetzung hergestellt ist, die mindestens Folgendes umfasst;

i) ein reaktives Monomer; und
ii) eine lichtemittierende Komponente;
und das reaktive Monomer der Zusammensetzung ein (Meth)acrylatmonomer ist, das aus einem Mono(meth) acrylatmonomer, einem Di(meth)acrylatmonomer oder einem Tri(meth)acrylatmonomer ausgewählt ist; und wobei die Zusammensetzung ferner ein (Meth)acrylatmonomer, das durch die folgende chemische Formel (I) dargestellt ist, und/oder ein (Meth)acrylatmonomer, das durch die folgende chemische Formel (III) dargestellt ist, umfasst;

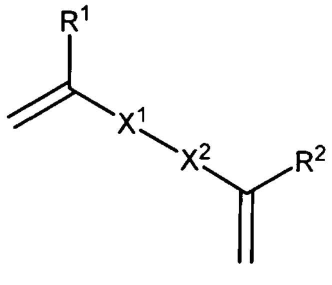

(I)

wobei $X^1$ eine nicht substituierte oder substituierte Alkylgruppe, Arylgruppe oder eine Alkoxygruppe oder eine Estergruppe ist;
$X^2$ eine nicht substituierte oder substituierte Alkylgruppe, Arylgruppe oder eine Alkoxygruppe oder eine Estergruppe ist;
$R^1$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;
$R^2$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

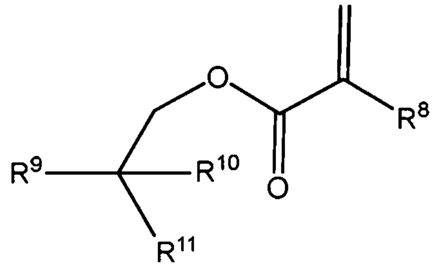

(III);

wobei $R^9$ ein Wasserstoffatom, eine gerade Alkylgruppe mit 1 bis 25 Kohlenstoffatomen oder eine (Meth) acrylgruppe, die durch die chemische Formel (IV) dargestellt ist, ist

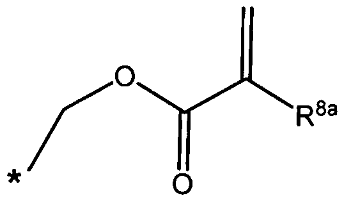

(IV);

$R^{10}$ ein Wasserstoffatom, eine gerade Alkylgruppe mit 1 bis 25 Kohlenstoffatomen oder eine (Meth)acrylgruppe, die durch die chemische Formel (V) dargestellt ist, ist

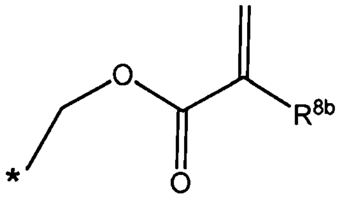

(V);

$R^{11}$ ein Wasserstoffatom, eine gerade Alkylgruppe mit 1 bis 25 Kohlenstoffatomen oder eine (Meth)acrylgruppe, die durch die chemische Formel (VI) dargestellt ist, ist

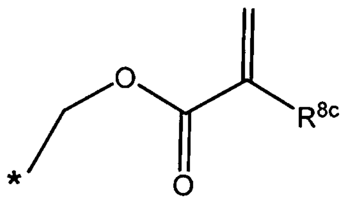

(VI);

wobei $R^8$, $R^{8a}$, $R^{8b}$ und $R^{8c}$ jeweils unabhängig oder abhängig voneinander bei jedem Auftreten H, $CH_2CH_3$ oder $CH_3$ sind;

wobei mindestens eines von $R^9$, $R^{10}$ und $R^{11}$ eine (Meth)acrylgruppe ist, bevorzugt zwei von $R^9$, $R^{10}$ und $R^{11}$ eine (Meth)acrylgruppe sind und ein anderes ein Wasserstoffatom oder eine gerade Alkylgruppe mit 1 bis 25 Kohlenstoffatomen ist.

**5.** Schicht (100) nach einem der Ansprüche 1 bis 4, wobei die Schichtdicke der Schicht (100) im Bereich von 1 bis 50 um liegt.

**6.** Schicht (100) nach einem der Ansprüche 1 bis 5 zeigt den EQE-Wert von 25 % oder mehr und weniger als 50 %.

**7.** Schicht (100) nach einem der Ansprüche 1 bis 6 ist aus der Zusammensetzung hergestellt, bevorzugt aus einer photohärtbaren Zusammensetzung, die ferner Folgendes umfasst

iii) eine chemische Verbindung, die mindestens eine Endgruppe umfasst, die aus einem oder mehreren Mitgliedern

der Gruppe ausgewählt ist, die aus einer Phosphingruppe, einer Phosphinoxidgruppe, einer Phosphatgruppe, einer Phosphonatgruppe, einer Thiolgruppe, einer tertiären Amingruppe, einer primären Amingruppe, einer Carboxylgruppe, einer heterocyclischen Gruppe, einer Silangruppe, einer Sulfonsäuregruppe, einer Hydroxylgruppe, einer Phosphonsäuregruppe besteht.

8. Schicht (100) nach Anspruch 7, wobei das reaktive Monomer der Zusammensetzung durch die folgende chemische Formel (II) dargestellt ist;

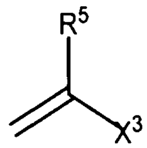

(II)

$X^3$ eine nicht substituierte oder substituierte Alkylgruppe, Arylgruppe oder eine Alkoxygruppe ist;
bevorzugt das Symbol $X^3$

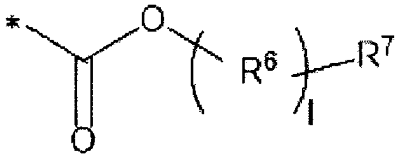

ist,
wobei "*" auf der linken Seite der Formel den Verbindungspunkt zu der Endgruppe $C=CR^5$ der Formel (I) darstellt;
1 0 oder 1 ist;
$R^5$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;
$R^6$ eine gerade Alkylenkette oder Alkoxylenkette mit 1 bis 25 Kohlenstoffatomen ist, bevorzugt $R^6$ eine gerade Alkylenkette oder Alkoxylenkette mit 1 bis 15 Kohlenstoffatomen, stärker bevorzugt 1 bis 5 Kohlenstoffatomen ist, was durch einen oder mehrere Reste $R^a$ substituiert sein kann, wobei eine oder mehrere nicht benachbarte $CH_2$-Gruppen durch $R^aC=CR^a$, C≡C, $Si(R^a)_2$, $Ge(R^a)_2$, $Sn(R^a)_2$, C=O, O, C=S, C=Se, $C=NR^a$, P(=O) ($R^a$), SO, SO2, $NR^a$, OS oder $CONR^a$ ersetzt sein können und wobei ein oder mehrere H-Atome durch D, F, Cl, Br, I, CN oder $NO_2$ ersetzt sein können;
$R^7$ eine gerade Alkylkette oder Alkoxylkette mit 1 bis 25 Kohlenstoffatomen ist, bevorzugt $R^7$ eine gerade Alkylkette oder Alkoxylkette mit 1 bis 15 Kohlenstoffatomen, stärker bevorzugt 1 bis 5 Kohlenstoffatomen ist, was durch einen oder mehrere Reste $R^a$ substituiert sein kann, wobei eine oder mehrere nicht benachbarte $CH_2$-Gruppen durch $R^aC=CR^a$, C≡C, $Si(R^a)_2$, $Ge(R^a)_2$, $Sn(R^a)_2$, C=O, O, C=S, C=Se, $C=NR^a$, P(=O) ($R^a$), SO, SO2, $NR^a$, OS oder $CONR^a$ ersetzt sein können und wobei ein oder mehrere H-Atome durch D, F, Cl, Br, I, CN oder $NO_2$ ersetzt sein können;
$R^a$ bei jedem Vorkommen gleich oder unterschiedlich H, D oder eine Alkylgruppe mit 1 bis 20 Kohlenstoffatomen, cyclische Alkyl- oder Alkoxygruppe mit 3 bis 40 Kohlenstoffatomen, ein aromatisches Ringsystem mit 5 bis 60 Kohlenstoffatomen oder ein heteroaromatisches Ringsystem mit 5 bis 60 Kohlenstoffatomen ist, wobei H-Atome durch D, F, Cl, Br, I ersetzt sein können; zwei oder mehr benachbarte Substituenten $R^a$ hier auch miteinander ein mono- oder polycyclisches, aliphatisches, aromatisches oder heteroaromatisches Ringsystem bilden können.

9. Schicht (100) nach Anspruch 7 oder 8, wobei das (Meth)acrylatmonomer der chemischen Formel (II) in der Zusammensetzung ist und das Mischungsverhältnis des (Meth)acrylatmonomers der chemischen Formel (I) zu dem (Meth)acrylatmonomer der chemischen Formel (II) im Bereich von 1:99 bis 99:1 (Formel (I) : Formel (II)) liegt, bevorzugt von 5:95 bis 50:50, stärker bevorzugt von 10:90 bis 40:60, es noch stärker bevorzugt von 15:85 bis 35:65 beträgt, bevorzugt mindestens ein gereinigtes (Meth)acrylatmonomer, das durch die chemische Formel (I), (II) dargestellt ist, in der Zusammensetzung verwendet wird, besonders bevorzugt das (Meth)acrylatmonomer der chemischen Formel (I) und das (Meth)acrylatmonomer der chemischen Formel (II) beide durch ein Reinigungsverfahren erhalten werden oder erhaltbar sind.

10. Schicht (100) nach einem der Ansprüche 1 bis 9 umfasst ein weiteres Material, das aus einem oder mehreren Mitgliedern der Gruppe ausgewählt ist, die aus Folgenden besteht;

einer weiteren lichtemittierenden Komponente, die sich von der lichtemittierenden Komponente nach Anspruch 1 unterscheidet, streuenden Teilchen, transparenten Polymeren, Antioxidantien, Radikalfängern, Photoinitiatoren und Tensiden.

**11.** Mehrfachschicht (300), enthaltend mindestens die Schicht nach einem der Ansprüche 1 bis 10 und eine weitere Schicht (310), die direkt an der Schicht angebracht ist.

**12.** Farbumwandlungsvorrichtung (400), umfassend mindestens xi) ein Pixel, das teilweise oder vollständig mit der Schicht (100) nach einem der Ansprüche 1 bis 10 oder der Mehrfachschicht (300) nach Anspruch 11 gefüllt ist, wobei optional eine oder mehrere weitere Schichten (420) unter und/oder über der Schicht (100) in dem Pixel platziert sind; und
xii) eine Bank (430), die mindestens ein Polymermaterial umfasst.

**13.** Optische Vorrichtung (500), enthaltend mindestens ein Funktionsmedium (510), das dazu konfiguriert ist, ein Licht zu modulieren, oder dazu konfiguriert ist, Licht zu emittieren, und die Farbumwandlungsvorrichtung (400) nach Anspruch 12.

## Revendications

**1.** Couche (100) comprenant au moins un matériau de matrice (110) et un ou plusieurs groupements électroluminescents (120), dans laquelle la distribution du groupement électroluminescent (120) dans la couche n'est pas identique dans la direction de l'épaisseur de la couche ;

dans laquelle ladite couche est fabriquée à partir d'une composition, de préférence fabriquée à partir d'une composition photodurcissable, comprenant au moins :

i) un monomère réactif ; et
ii) un groupement électroluminescent ;

et ledit monomère réactif de la composition est un monomère de (méth)acrylate choisi parmi un monomère de mono- (méth)acrylate, un monomère de di-(méth)acrylate ou un monomère de tri-(méth)acrylate ; et
dans laquelle la composition comprend en outre un monomère de (méth)acrylate représenté par la formule chimique (I) suivante et/ou un monomère de (méth)acrylate représenté par la formule chimique (III) suivante ;

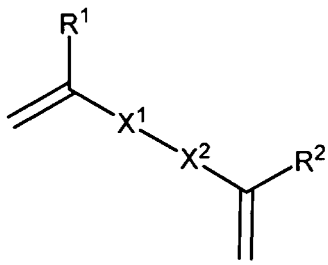

(I)

dans laquelle
$X^1$ est un groupe alkyle, un groupe aryle, un groupe alcoxy ou un groupe ester non substitué ou substitué ;
$X^2$ est un groupe alkyle, un groupe aryle, un groupe alcoxy ou un groupe ester non substitué ou substitué ;
$R^1$ est un atome hydrogène, un atome halogène de Cl, Br ou F, un groupe méthyle, un groupe alkyle, un groupe aryle, un groupe alcoxy, un groupe ester ou un groupe acide carboxylique ;
$R^2$ est un atome hydrogène, un atome halogène de Cl, Br ou F, un groupe méthyle, un groupe alkyle, un groupe aryle, un groupe alcoxy, un groupe ester ou un groupe acide carboxylique ;

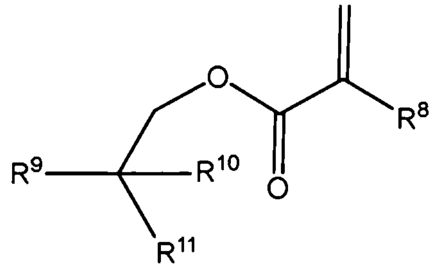

(III);

dans laquelle $R^9$ est un atome hydrogène, un groupe alkyle linéaire comportant de 1 à 25 atomes de carbone ou un groupe (méth)acrylique représenté par la formule chimique (IV)

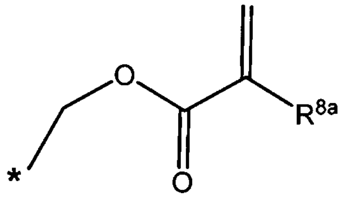

(IV);

$R^{10}$ est un atome hydrogène, un groupe alkyle linéaire comportant de 1 à 25 atomes de carbone ou un groupe (méth)acrylique représenté par la formule chimique (V)

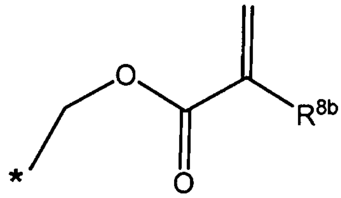

(V);

$R^{11}$ est un atome hydrogène, un groupe alkyle linéaire comportant de 1 à 25 atomes de carbone ou un groupe (méth)acrylique représenté par la formule chimique (VI)

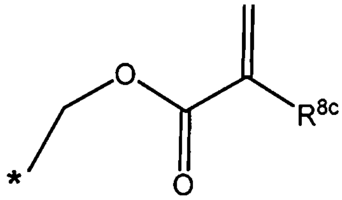

(VI);

dans laquelle $R^8$, $R^{8a}$, $R^{8b}$ et $R^{8c}$ sont, chacun indépendamment ou dépendamment les uns des autres à chaque occurrence, H, $CH_2CH_3$ ou $CH_3$ ;
dans laquelle au moins un parmi $R^9$, $R^{10}$ et $R^{11}$ est un groupe (méth)acrylique, de préférence deux parmi $R^9$, $R^{10}$ et $R^{11}$ sont un groupe (méth)acrylique et l'autre est un atome hydrogène ou un groupe alkyle linéaire comportant 1 à 25 atomes de carbone.

**2.** Couche (100) contenant au moins un matériau de matrice (110) et un ou plusieurs groupements électroluminescents (120), contient une 1ère phase (210) et une 2ème phase (220), dans laquelle ladite 1ère phase (210) et ladite 2ème phase (220) sont différentes l'une de l'autre et ladite 1ère phase (210) comporte une pluralité d'agrégats (211) desdits groupements électroluminescents (120) et une concentration plus élevée des groupements électroluminescents par unité de volume dans la 1ère phase (210) que dans la 2ème phase (220) ;

dans laquelle ladite couche est fabriquée à partir d'une composition, de préférence fabriquée à partir d'une composition photodurcissable, comprenant au moins :

i) un monomère réactif ; et
ii) un groupement électroluminescent ;

et ledit monomère réactif de la composition est un monomère de (méth)acrylate choisi parmi un monomère de mono- (méth)acrylate, un monomère de di-(méth)acrylate ou un monomère de tri-(méth)acrylate ; et dans laquelle la composition comprend en outre un monomère de (méth)acrylate représenté par la formule chimique (I) suivante et/ou un monomère de (méth)acrylate représenté par la formule chimique (III) suivante ;

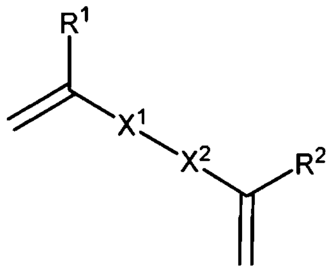

(I)

dans laquelle
$X^1$ est un groupe alkyle, un groupe aryle, un groupe alcoxy ou un groupe ester non substitué ou substitué ;
$X^2$ est un groupe alkyle, un groupe aryle, un groupe alcoxy ou un groupe ester non substitué ou substitué ;
$R^1$ est un atome hydrogène, un atome halogène de Cl, Br ou F, un groupe méthyle, un groupe alkyle, un groupe aryle, un groupe alcoxy, un groupe ester ou un groupe acide carboxylique ;
$R^2$ est un atome hydrogène, un atome halogène de Cl, Br ou F, un groupe méthyle, un groupe alkyle, un groupe aryle, un groupe alcoxy, un groupe ester ou un groupe acide carboxylique ;

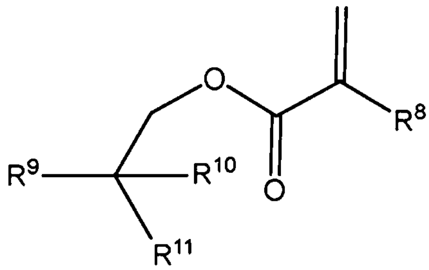

(III);

dans laquelle $R^9$ est un atome hydrogène, un groupe alkyle linéaire comportant de 1 à 25 atomes de carbone ou un groupe (méth)acrylique représenté par la formule chimique (IV)

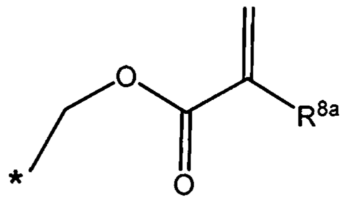

(IV);

$R^{10}$ est un atome hydrogène, un groupe alkyle linéaire comportant de 1 à 25 atomes de carbone ou un groupe (méth)acrylique représenté par la formule chimique (V)

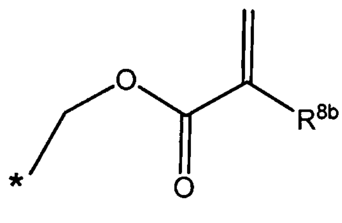

(V);

$R^{11}$ est un atome hydrogène, un groupe alkyle linéaire comportant de 1 à 25 atomes de carbone ou un groupe (méth)acrylique représenté par la formule chimique (VI)

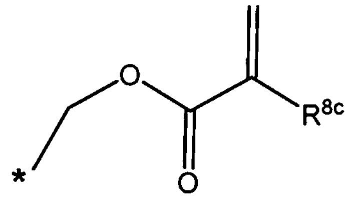

(VI);

dans laquelle $R^8$, $R^{8a}$, $R^{8b}$ et $R^{8c}$ sont, chacun indépendamment ou dépendamment les uns des autres à chaque occurrence, H, $CH_2CH_3$ ou $CH_3$ ;
dans laquelle au moins un parmi $R^9$, $R^{10}$ et $R^{11}$ est un groupe (méth)acrylique, de préférence deux parmi $R^9$, $R^{10}$ et $R^{11}$ sont un groupe (méth)acrylique et l'autre est un atome hydrogène ou un groupe alkyle linéaire comportant 1 à 25 atomes de carbone.

**3.** Couche (100) contenant au moins un matériau de matrice (110) et un ou plusieurs groupements électroluminescents (120), dans laquelle 30 % en poids ou plus des groupements électroluminescents (120) sur la base de la quantité totale des groupements électroluminescents dans la couche sont concentrés dans une zone (160) de la couche, dans laquelle ladite zone (160) comporte une épaisseur inférieure comprise dans les 25 % de l'épaisseur de la couche ;

dans laquelle ladite couche est fabriquée à partir d'une composition, de préférence fabriquée à partir d'une composition photodurcissable, comprenant au moins :

i) un monomère réactif ; et
ii) un groupement électroluminescent ;

et ledit monomère réactif de la composition est un monomère de (méth)acrylate choisi parmi un monomère de mono- (méth)acrylate, un monomère de di-(méth)acrylate ou un monomère de tri-(méth)acrylate ; et
dans laquelle la composition comprend en outre un monomère de (méth)acrylate représenté par la formule chimique (I) suivante et/ou un monomère de (méth)acrylate représenté par la formule chimique (III) suivante ;

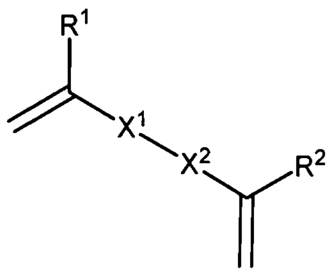

(I)

dans laquelle
$X^1$ est un groupe alkyle, un groupe aryle, un groupe alcoxy ou un groupe ester non substitué ou substitué ;
$X^2$ est un groupe alkyle, un groupe aryle, un groupe alcoxy ou un groupe ester non substitué ou substitué ;
$R^1$ est un atome hydrogène, un atome halogène de Cl, Br ou F, un groupe méthyle, un groupe alkyle, un groupe aryle, un groupe alcoxy, un groupe ester ou un groupe acide carboxylique ;
$R^2$ est un atome hydrogène, un atome halogène de Cl, Br ou F, un groupe méthyle, un groupe alkyle, un groupe aryle, un groupe alcoxy, un groupe ester ou un groupe acide carboxylique ;

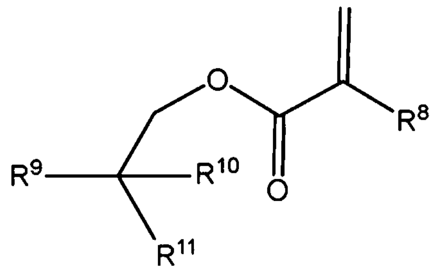

(III);

dans laquelle $R^9$ est un atome hydrogène, un groupe alkyle linéaire comportant de 1 à 25 atomes de carbone ou un groupe (méth)acrylique représenté par la formule chimique (IV)

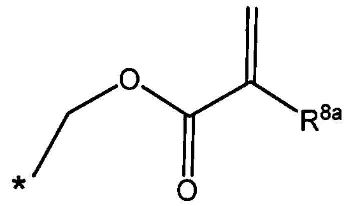

(IV);

$R^{10}$ est un atome hydrogène, un groupe alkyle linéaire comportant de 1 à 25 atomes de carbone ou un groupe (méth)acrylique représenté par la formule chimique (V)

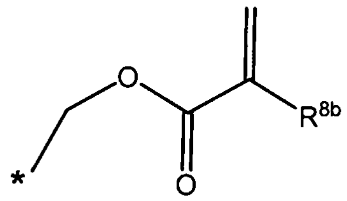

(V);

$R^{11}$ est un atome hydrogène, un groupe alkyle linéaire comportant de 1 à 25 atomes de carbone ou un groupe (méth)acrylique représenté par la formule chimique (VI)

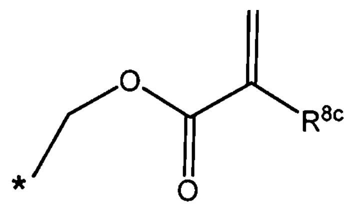

(VI);

dans laquelle $R^8$, $R^{8a}$, $R^{8b}$ et $R^{8c}$ sont, chacun indépendamment ou dépendamment les uns des autres à chaque occurrence, H, $CH_2CH_3$ ou $CH_3$ ;
dans laquelle au moins un parmi $R^9$, $R^{10}$ et $R^{11}$ est un groupe (méth)acrylique, de préférence deux parmi $R^9$, $R^{10}$ et $R^{11}$ sont un groupe (méth)acrylique et l'autre est un atome hydrogène ou un groupe alkyle linéaire comportant 1 à 25 atomes de carbone.

**4.** Couche (100) contenant au moins un matériau de matrice (110) et un ou plusieurs groupements électroluminescents (120), dans laquelle 41 % en poids ou plus des groupements électroluminescents (120) sur la base de la quantité totale des groupements électroluminescents dans la couche sont concentrés dans la zone (160) de la couche, dans laquelle ladite zone (160) comporte l'épaisseur comprise dans les 40 % de l'épaisseur de couche de la couche ; dans laquelle ladite couche est fabriquée à partir d'une composition, de préférence fabriquée à partir d'une composition photodurcissable, comprenant au moins :

i) un monomère réactif ; et

ii) un groupement électroluminescent ;

et ledit monomère réactif de la composition est un monomère de (méth)acrylate choisi parmi un monomère de mono- (méth)acrylate, un monomère de di-(méth)acrylate ou un monomère de tri-(méth)acrylate ; et

dans laquelle la composition comprend en outre un monomère de (méth)acrylate représenté par la formule chimique (I) suivante et/ou un monomère de (méth)acrylate représenté par la formule chimique (III) suivante ;

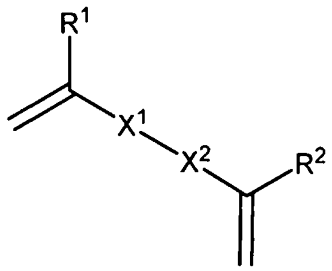

(I)

dans laquelle

$X^1$ est un groupe alkyle, un groupe aryle, un groupe alcoxy ou un groupe ester non substitué ou substitué ;

$X^2$ est un groupe alkyle, un groupe aryle, un groupe alcoxy ou un groupe ester non substitué ou substitué ; $R^1$ est un atome hydrogène, un atome halogène de Cl, Br ou F, un groupe méthyle, un groupe alkyle, un groupe aryle, un groupe alcoxy, un groupe ester ou un groupe acide carboxylique ;

$R^2$ est un atome hydrogène, un atome halogène de Cl, Br ou F, un groupe méthyle, un groupe alkyle, un groupe aryle, un groupe alcoxy, un groupe ester ou un groupe acide carboxylique ;

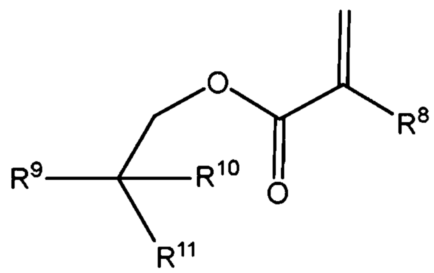

(III);

dans laquelle $R^9$ est un atome hydrogène, un groupe alkyle linéaire comportant de 1 à 25 atomes de carbone ou un groupe (méth)acrylique représenté par la formule chimique (IV)

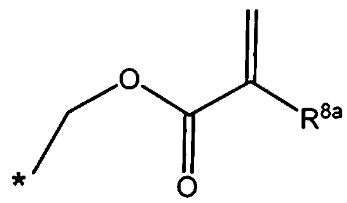

(IV);

$R^{10}$ est un atome hydrogène, un groupe alkyle linéaire comportant de 1 à 25 atomes de carbone ou un groupe (méth)acrylique représenté par la formule chimique (V)

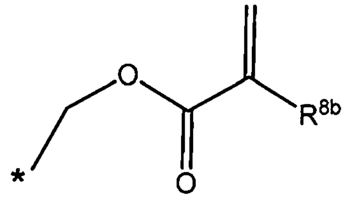

(V);

$R^{11}$ est un atome hydrogène, un groupe alkyle linéaire comportant de 1 à 25 atomes de carbone ou un groupe

(méth)acrylique représenté par la formule chimique (VI)

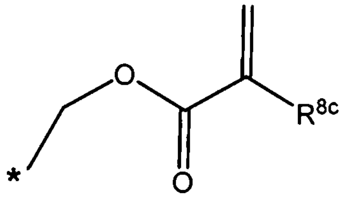

(VI);

dans laquelle $R^8$, $R^{8a}$, $R^{8b}$ et $R^{8c}$ sont, chacun indépendamment ou dépendamment les uns des autres à chaque occurrence, H, $CH_2CH_3$ ou $CH_3$ ;
dans laquelle au moins un parmi $R^9$, $R^{10}$ et $R^{11}$ est un groupe (méth)acrylique, de préférence deux parmi $R^9$, $R^{10}$ et $R^{11}$ sont un groupe (méth)acrylique et l'autre est un atome hydrogène ou un groupe alkyle linéaire comportant 1 à 25 atomes de carbone.

**5.** Couche (100) selon l'une quelconque des revendications 1 à 4, dans laquelle l'épaisseur de couche de la couche (100) est comprise dans la plage de 1 à 50 um.

**6.** Couche (100) selon l'une quelconque des revendications 1 à 5, présentant la valeur EQE de 25 % ou plus et de moins de 50 %.

**7.** Couche (100) selon l'une quelconque des revendications 1 à 6, fabriquée à partir de la composition, de préférence à partir d'une composition photodurcissable, comprenant en outre
iii) un composé chimique comprenant au moins un groupe terminal choisi parmi un ou plusieurs des membres du groupe constitué par un groupe phosphine, un groupe oxyde de phosphine, un groupe phosphate, un groupe phosphonate, un groupe thiol, un groupe amine tertiaire, un groupe amine primaire, un groupe carboxyle, un groupe hétérocyclique, un groupe silane, un groupe acide sulfonique, un groupe hydroxyle, un groupe acide phosphonique.

**8.** Couche (100) selon la revendication 7, dans laquelle le monomère réactif de la composition est représenté par la formule chimique (II) suivante :

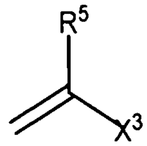

(II)

$X^3$ est un groupe alkyle, un groupe aryle ou un groupe alcoxy non substitué ou substitué ;
de préférence le symbole $X^3$ est

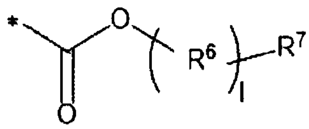

où « * » sur le côté gauche de la formule représente le point de liaison au groupe terminal $C{=}CR^5$ de la formule (I) ;
l vaut 0 ou 1 ;
$R^5$ est un atome hydrogène, un atome halogène de Cl, Br ou F, un groupe méthyle, un groupe alkyle, un groupe aryle, un groupe alcoxy, un groupe ester ou un groupe acide carboxylique ;
$R^6$ est une chaîne alkylène ou une chaîne alcoxylène linéaire comportant 1 à 25 atomes de carbone, de préférence $R^6$ est une chaîne alkylène ou une chaîne alcoxylène linéaire comportant 1 à 15 atomes de carbone, plus préférablement 1 à 5 atomes de carbone,
qui peut être substituée par un ou plusieurs radicaux $R^a$, où un ou plusieurs groupes $CH_2$ non adjacents peuvent être remplacés par $R^aC{=}CR^a$, $C{\equiv}C$, $Si(R^a)_2$, $Ge(R^a)_2$, $Sn(R^a)_2$, C=O, O, C=S, C=Se, $C{=}NR^a$, $P(=O)(R^a)$, SO, SO2, $NR^a$, OS ou $CONR^a$ et où un ou plusieurs atomes H peuvent être remplacés par D, F, Cl, Br, I, CN ou $NO_2$ ;
$R^7$ est une chaîne alkyle ou une chaîne alcoxyle linéaire comportant 1 à 25 atomes de carbone, de préférence $R^7$

est une chaîne alkyle ou une chaîne alcoxyle linéaire comportant 1 à 15 atomes de carbone, plus préférablement 1 à 5 atomes de carbone,
qui peut être substituée par un ou plusieurs radicaux $R^a$, où un ou plusieurs groupes $CH_2$ non adjacents peuvent être remplacés par $R^aC=CR^a$, C≡C, $Si(R^a)_2$, $Ge(R^a)_2$, $Sn(R^a)_2$, C=O, O, C=S, C=Se, $C=NR^a$, $P(=O)(R^a)$, SO, SO2, $NR^a$, OS ou $CONR^a$ et où un ou plusieurs atomes H peuvent être remplacés par D, F, Cl, Br, I, CN ou $NO_2$ ;
$R^a$ est à chaque occurrence, de manière identique ou différente, H, D ou un groupe alkyle comportant 1 à 20 atomes de carbone, un groupe alkyle ou alcoxy cyclique comportant 3 à 40 atomes de carbone, un système cyclique aromatique comportant 5 à 60 atomes de cycle de carbone, ou un système cyclique hétéroaromatique comportant 5 à 60 atomes de carbone, dans lequel les atomes H peuvent être remplacés par D, F, Cl, Br, I ; deux substituants $R^a$ adjacents ou plus peuvent également former un système cyclique mono- ou polycyclique, aliphatique, aromatique ou hétéroaromatique les uns avec les autres.

**9.** Couche (100) selon la revendication 7 ou 8, dans laquelle le monomère de (méth)acrylate de formule chimique (II) est dans la composition et le rapport de mélange du monomère de (méth)acrylate de formule chimique (I) au monomère de (méth)acrylate de formule chimique (II) est compris dans la plage de 1:99 à 99:1 (formule (I) : formule (II)), de préférence de 5: 95 à 50:50, plus préférablement de 10:90 à 40:60, encore plus préférablement il est de 15:85 à 35:65, de préférence au moins un monomère de (méth)acrylate purifié représenté par la formule chimique (I), (II) est utilisé dans la composition, plus préférablement le monomère de (méth)acrylate de formule chimique (I) et le monomère de (méth)acrylate de formule chimique (II) sont tous deux obtenus ou peuvent être obtenus par un procédé de purification.

**10.** Couche (100) selon l'une quelconque des revendications 1 à 9, comprenant un autre matériau sélectionné parmi un ou plusieurs membres du groupe constitué de :
un autre groupement électroluminescent qui est différent du groupement électroluminescent selon la revendication 1, des particules diffusantes, des polymères transparents, des antioxydants, des extincteurs de radicaux, des photoamorceurs et des tensioactifs.

**11.** Couche multiple (300) contenant au moins la couche selon l'une quelconque des revendications 1 à 10 et une autre couche (310) fixée directement sur la couche.

**12.** Dispositif de conversion de couleur (400) comprenant au moins xi) un pixel partiellement ou entièrement rempli de la couche (100) selon l'une quelconque des revendications 1 à 10 ou de la couche multiple (300) selon la revendication 11, éventuellement une ou plusieurs autres couches (420) placées sous et/ou au-dessus de la couche (100) dans le pixel ; et
xii) une paroi de confinement (430) comprenant au moins un matériau polymère.

**13.** Dispositif optique (500) contenant au moins un milieu fonctionnel (510) conçu pour moduler une lumière ou conçu pour émettre une lumière, et le dispositif de conversion de couleur (400) selon la revendication 12.

Fig. 1A

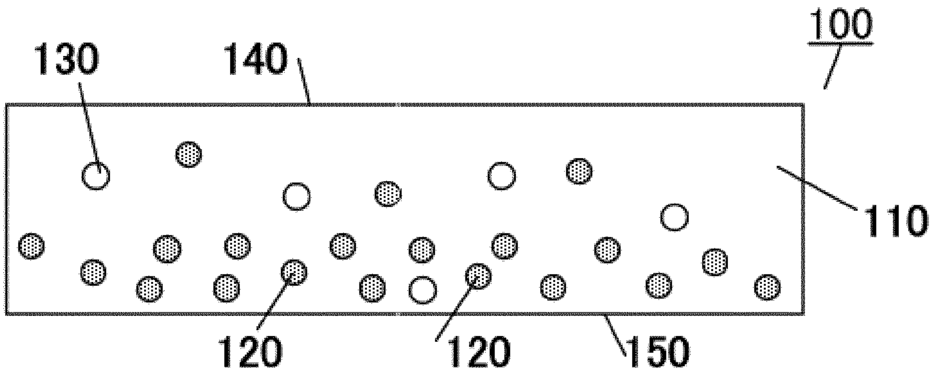
100
130
140
110
120
120
150

Fig. 1B

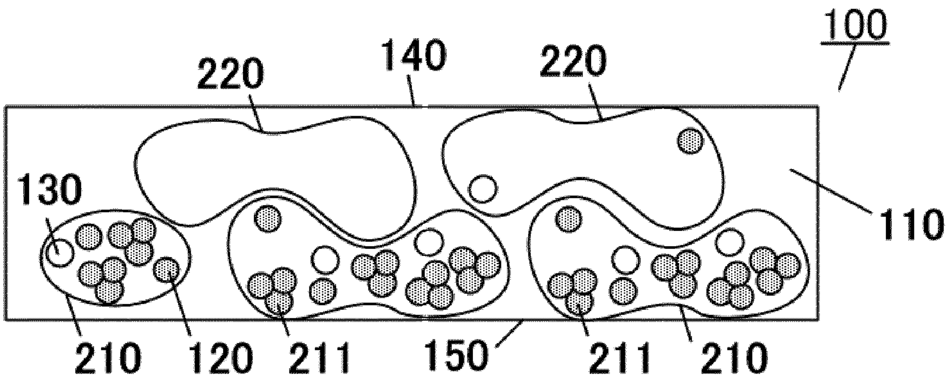
100
220
140
220
130
110
210
120
211
150
211
210

Fig. 1C

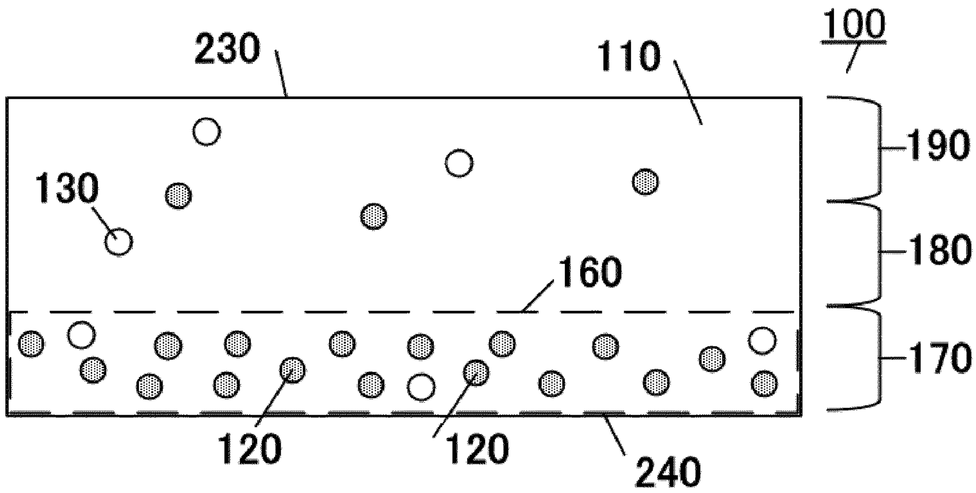
100
230
110
190
130
180
160
170
120
120
240

Fig. 1D

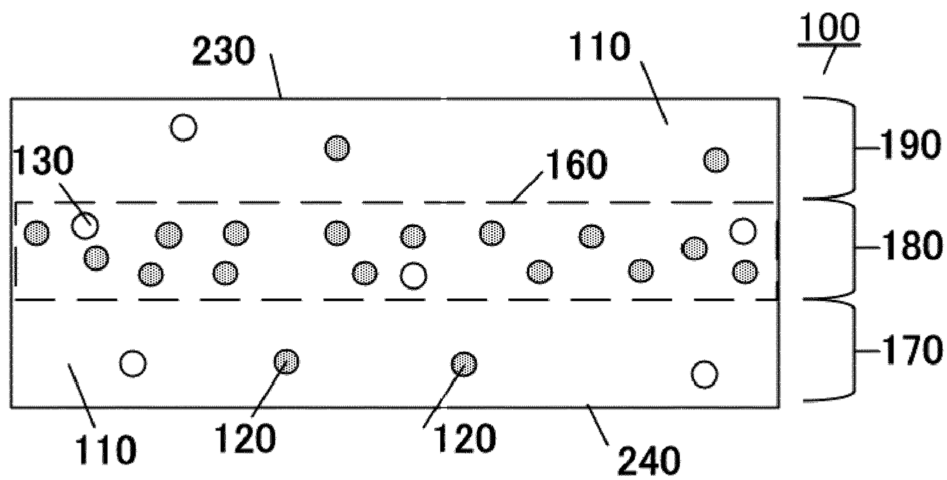
100
230
110
190
130
160
180
170
110
120
120
240

Fig. 2A

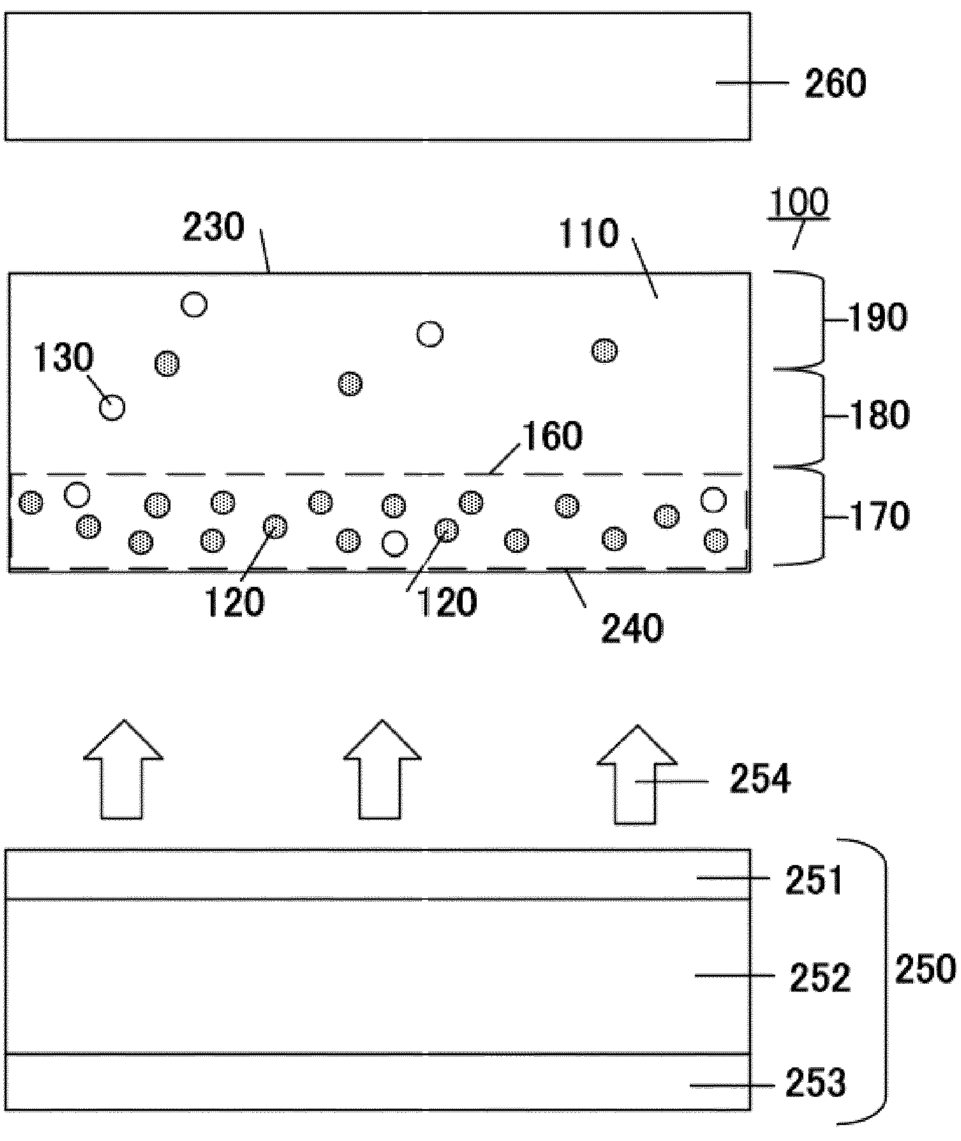
260
100
230
110
190
130
180
160
170
120
120
240
254
251
252
250
253

Fig. 2B

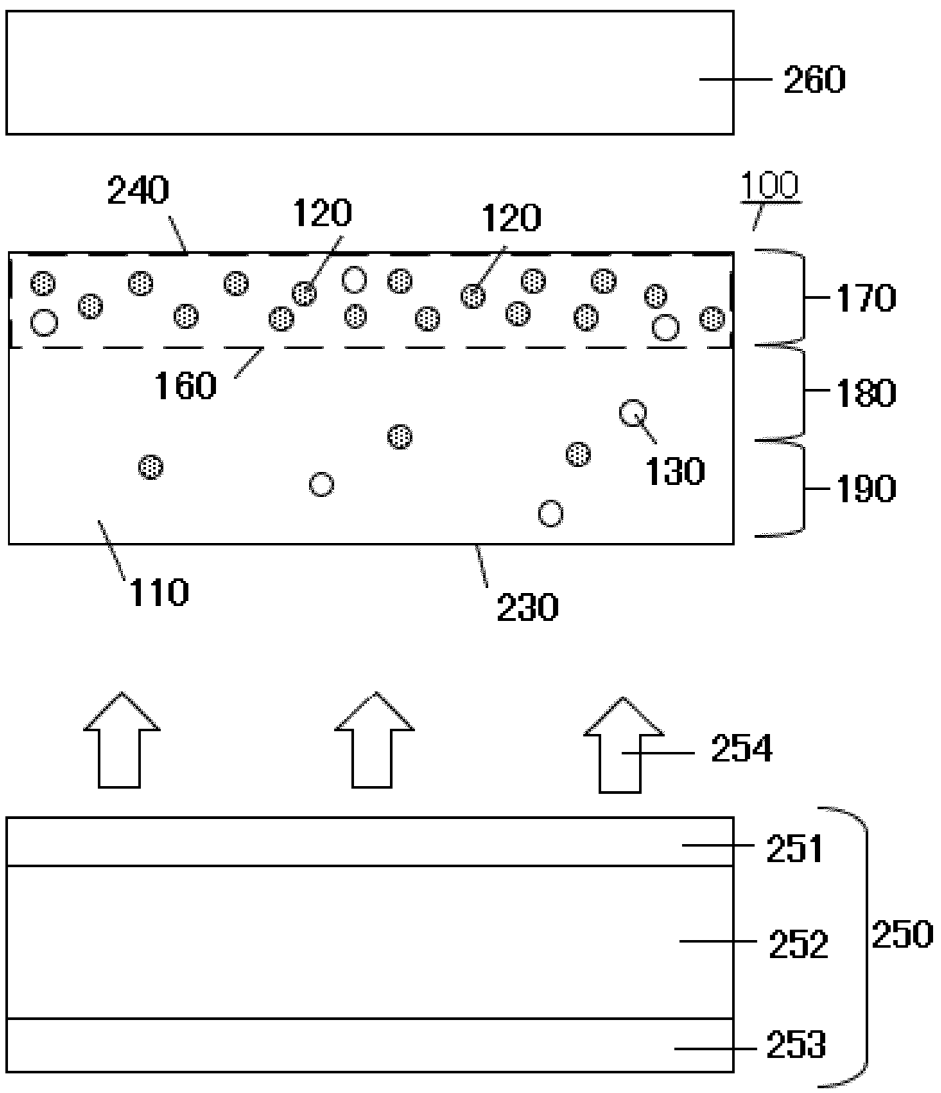
260
240
120
120
100
170
160
180
130
190
110
230
254
251
252
250
253

Fig. 3

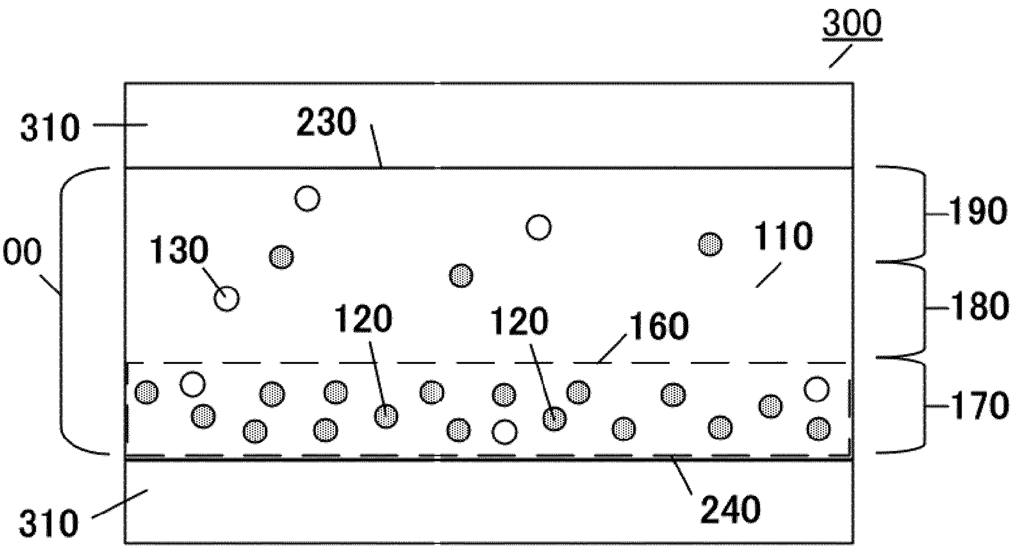
300
310
230
190
100
130
110
180
120
120
160
170
310
240

Fig. 4

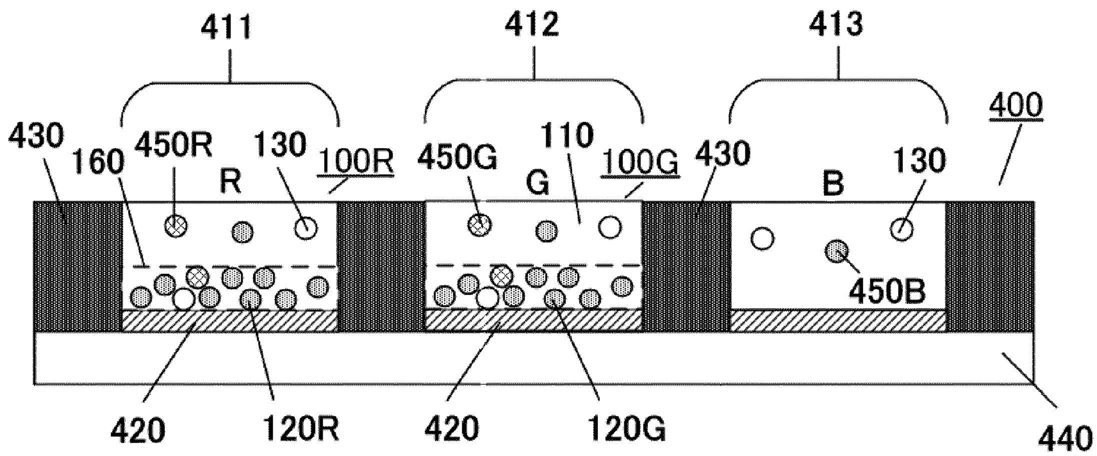
411
412
413
400
430
160
450R
R
130
100R
450G
G
110
100G
430
B
130
450B
420
120R
420
120G
440

Fig. 5A

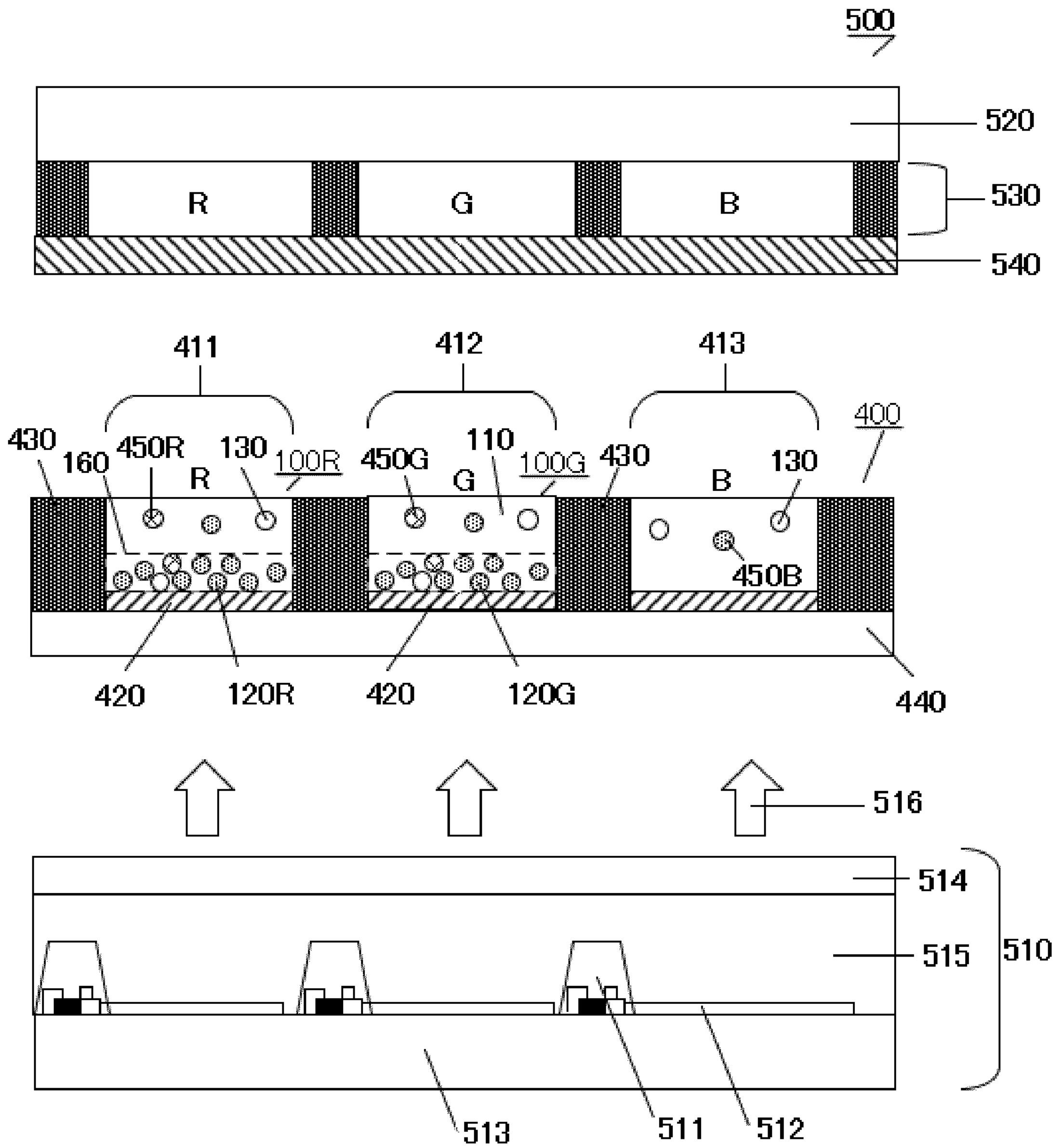
500
520
R
G
B
530
540
411
412
413
400
430
160
450R
130
100R
R
450G
110
G
100G
430
B
130
450B
420
120R
420
120G
440
516
514
515
510
513
511
512

Fig. 5B

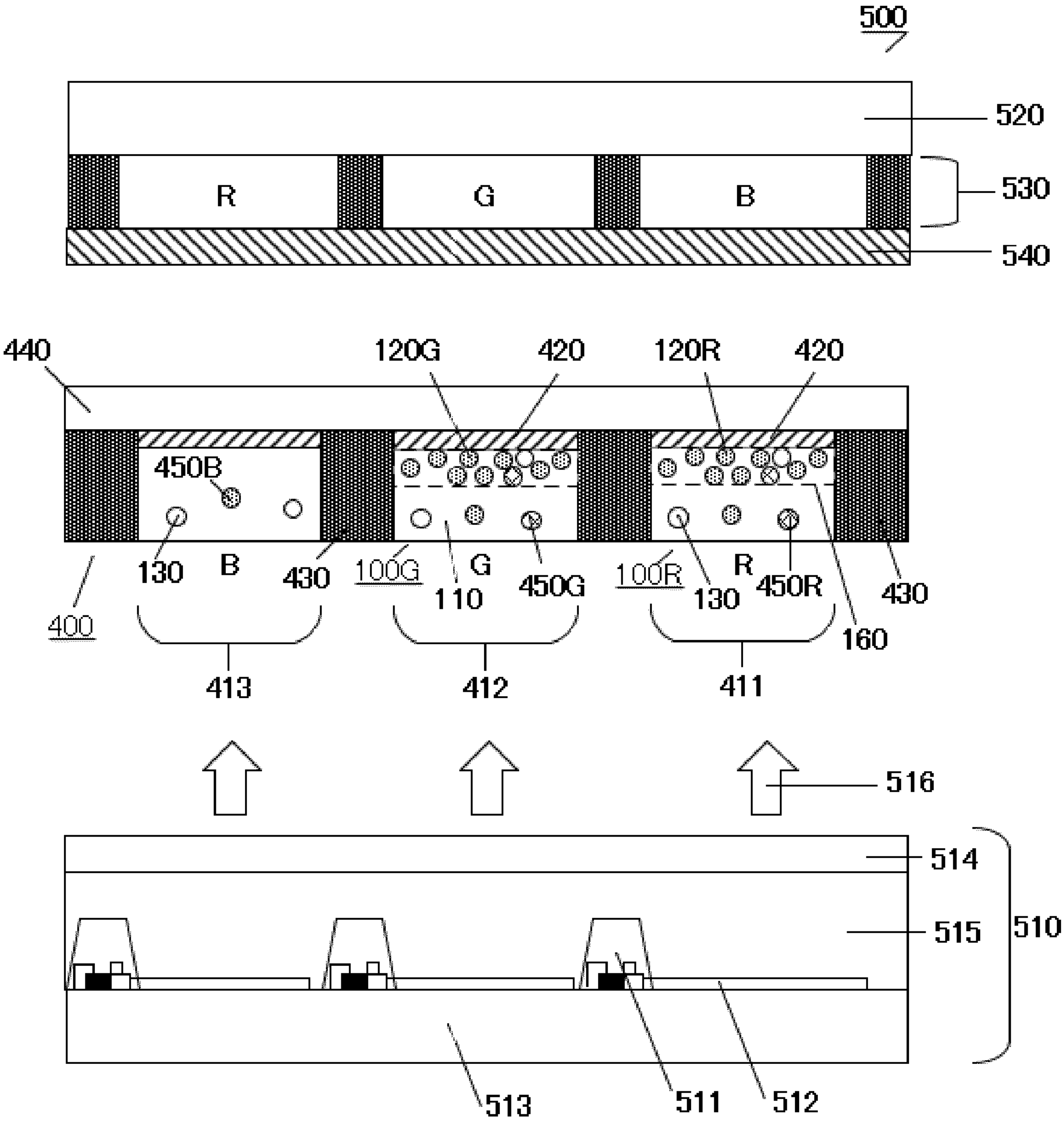
500
520
R
G
B
530
540
440
120G
420
120R
420
450B
130
B
430
100G
G
110
450G
100R
130
R
450R
430
160
400
413
412
411
516
514
515
510
513
511
512

Fig. 6A

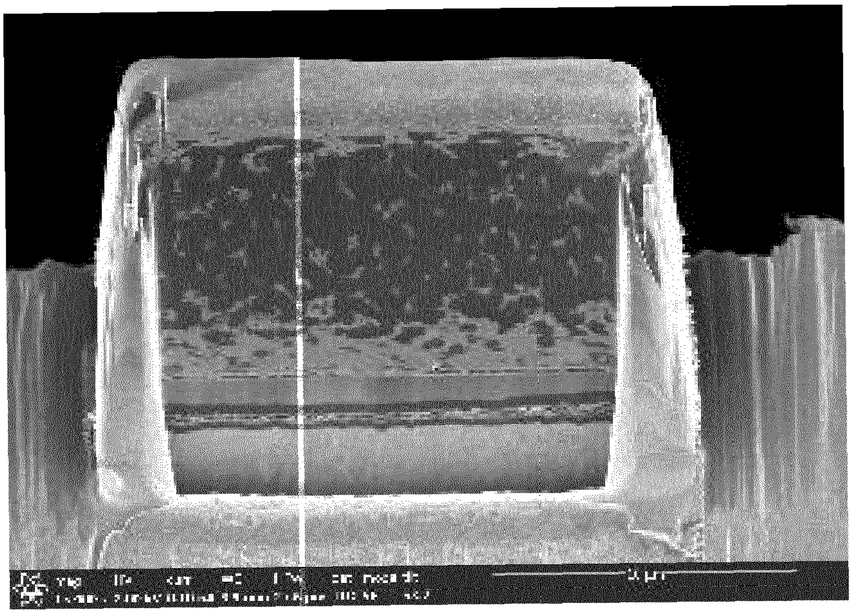

Fig. 6B

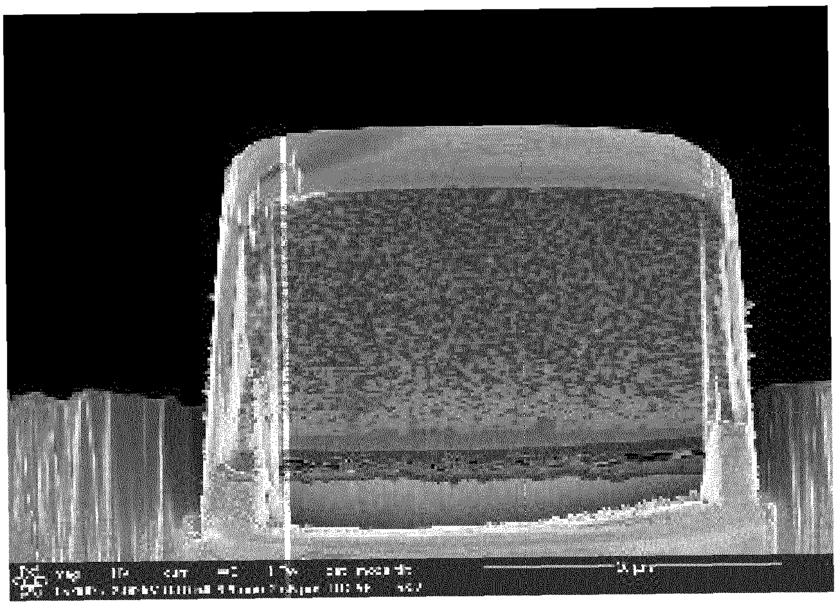

Fig. 7A

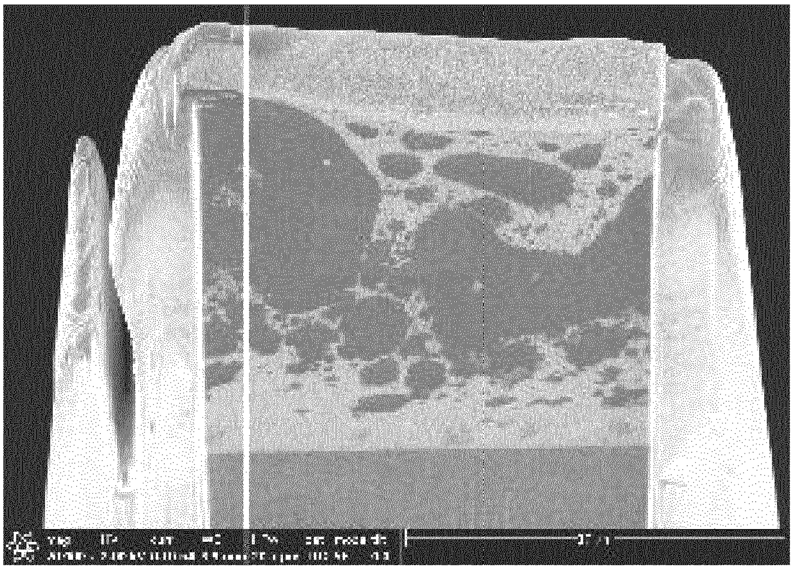

Fig. 7B

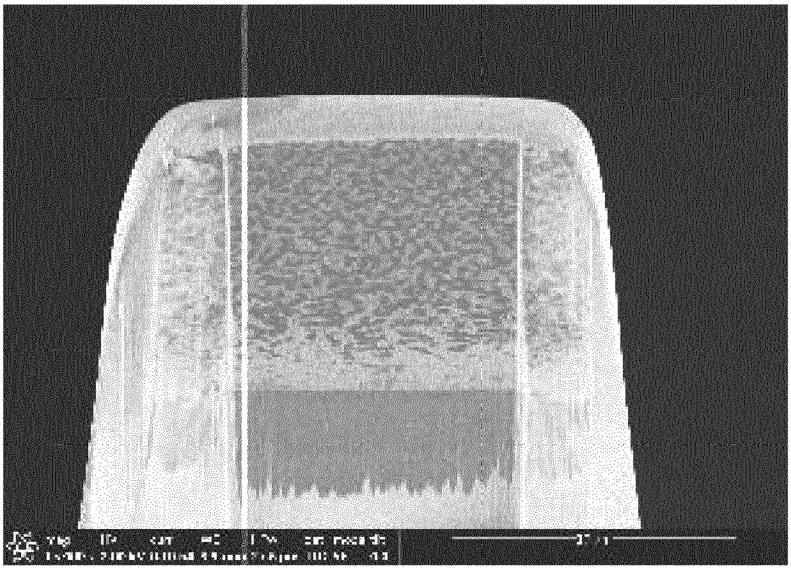

Fig. 8A

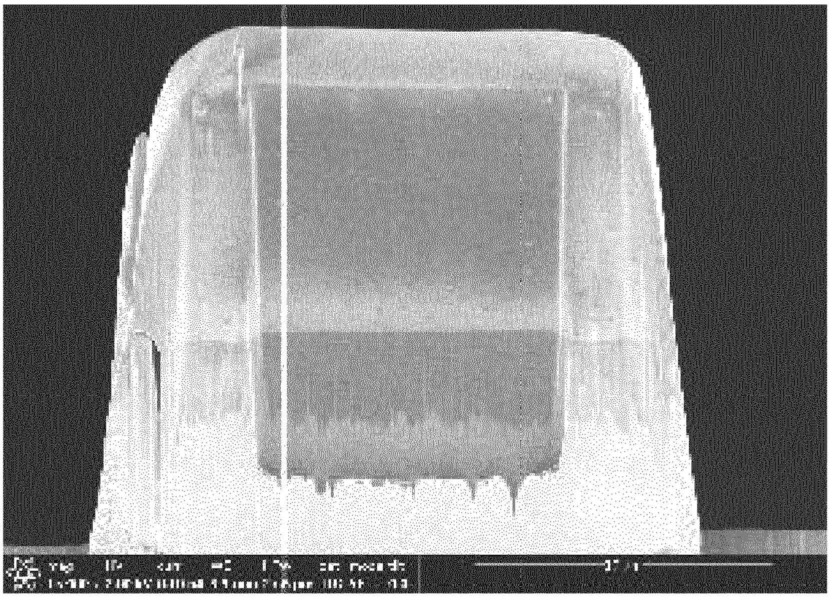

Fig. 8B

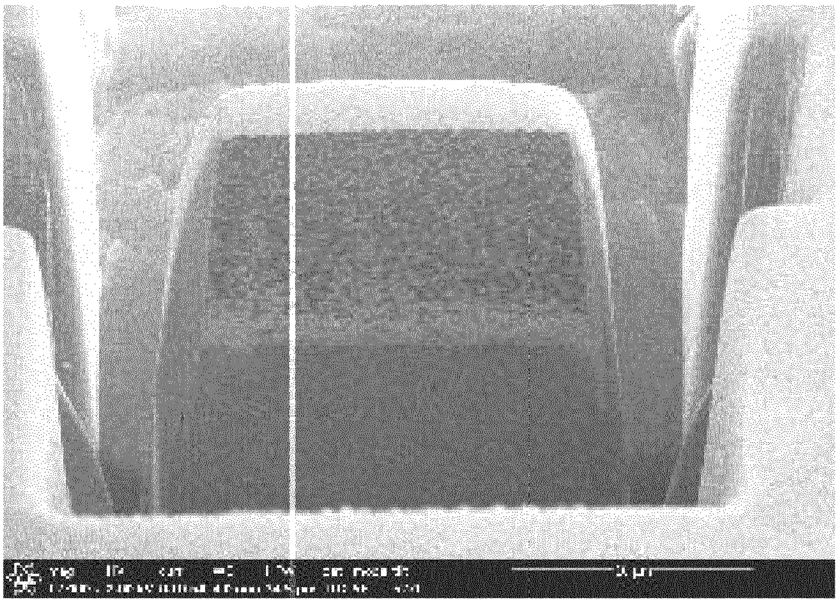

Fig. 9A

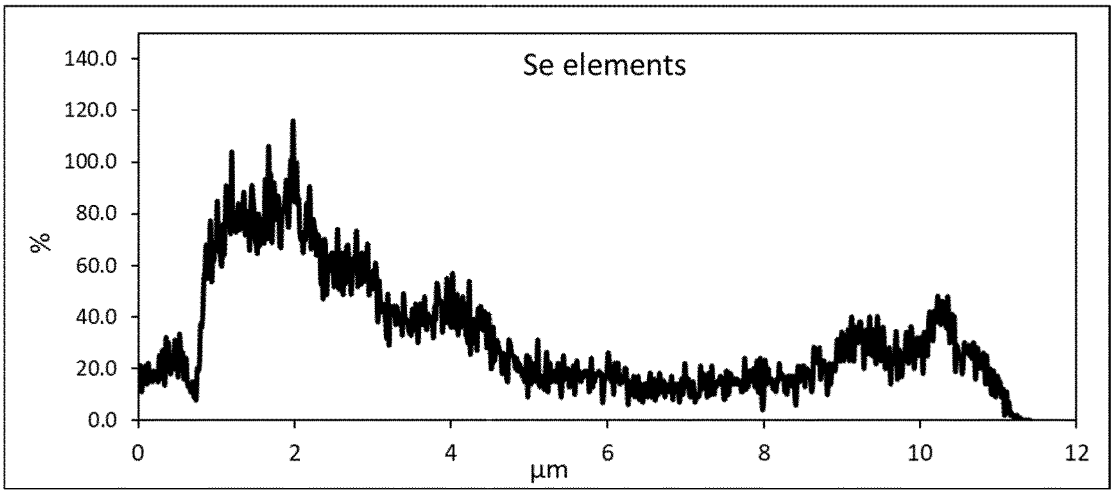
Se elements
140.0
120.0
100.0
80.0
60.0
40.0
20.0
0.0
%
0
2
4
6
8
10
12
µm

Fig. 9B

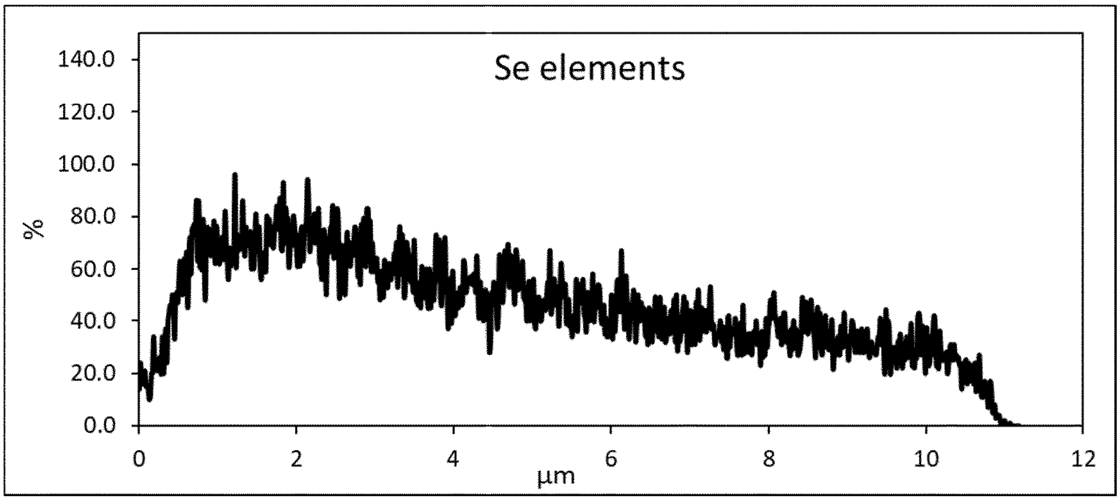
Se elements
140.0
120.0
100.0
80.0
60.0
40.0
20.0
0.0
%
0
2
4
6
8
10
12
µm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017054898 A1
- WO 2019002239 A1
- US 20070228932 A
- US 20160322542 A
- US 20160027971 A
- US 7588828 B
- US 8679543 B
- WO 2012059931 A
- WO 2016134820 A
- JP 2021075660 A
- WO 2017138607 A1
- JP 2018203599 A
- WO 2021018927 A1


### Non-patent literature cited in the description


- *Chem. Mater.*, 2015, vol. 27, 4893-4898
- **MARC THIRY**. ACSNANO. American Chemical society, 2011, vol. 5, 4965-4973
- **KIMIHIRO SUSUMU**. *J. Am. Chem. Soc.*, 2011, vol. 133, 9480-9496
- **RICKEY J SEYLER**. *Assignment of the Glass Transition*